# EUROPEAN PATENT APPLICATION

(11) **EP 4 804 239 A1**
(43) Date of publication of application: **09.09.2026**
(21) Application number: 24905491.7
(22) Date of filing: 09.07.2024
(51) Int. Cl.: H01L 23/528

(54) **STEPPED STRUCTURE AND MANUFACTURING METHOD THEREFOR, AND SEMICONDUCTOR STRUCTURE**

(30) Priority: 19.12.2023 CN 202311759267
(71) Applicant: CXMT Corporation, Hefei City, Anhui Province 230601 (CN)
(72) Inventor: WANG, Hong, Hefei, Anhui 230601 (CN)
(74) Representative: Gulde & Partner
(86) International application number: PCT/CN2024/104367
(87) International publication number: WO 2025/129992

(57) **Abstract**

Disclosed are a staircase structure, a method for manufacturing the same, and a semiconductor structure. The staircase structure includes: a plurality of conductive layers spaced apart along a first direction, where each conductive layer includes at least two sub-conductive layers spaced apart along a second direction, and the conductive layer extends along a third direction; and a plurality of step structures spaced apart along the second direction, one column of the sub-conductive layers spaced apart along the first direction being in contact connection with at least one step structure, where each step structure includes a plurality of conductive pillars electrically insulated from each other, one conductive pillar is in contact connection with one sub-conductive layer, and the conductive pillar in contact connection with the one sub-conductive layer is electrically insulated from the other sub-conductive layers; and in a column of the conductive layers spaced apart along the first direction, the conductive layers are in contact connection with the conductive pillars in a one-to-one manner. Embodiments of the present disclosure are at least beneficial to reducing the overall horizontal area occupied by the staircase structure and improving the integration density of the conductive pillars in the staircase structure.

## Description

The present application claims priority to Chinese Patent Application No. 202311759267.4, filed with China National Intellectual Property Administration on December 19, 2023, and entitled "STAIRCASE STRUCTURE, METHOD FOR MANUFACTURING SAME, AND SEMICONDUCTOR STRUCTURE", the content of which is incorporated herein by reference in its entirety.

### TECHNICAL FIELD

Embodiments of the present disclosure relate to the technical field of semiconductors, and in particular, to a staircase structure, a method for manufacturing the same, and a semiconductor structure.

### BACKGROUND

With the continuous development of semiconductor structures, the critical dimension of a semiconductor structure becomes increasingly smaller. However, due to the limitation of the lithography machine, there is a limit with regard to reducing the critical dimension. Therefore, many researchers and semiconductor industry professionals focus on studying how to produce chips with higher storage density on a wafer. Based on this, the development of semiconductor devices is heading toward three-dimensional semiconductor devices.

However, as the number of stacked layers of signal transmission layers, such as bit lines or word lines, in the three-dimensional semiconductor device increases, how to design a lead-out structure that occupies less layout space to transmit electrical signals on many signal transmission layers has become an urgent problem to be solved.

### SUMMARY

Embodiments of the present disclosure provide a staircase structure, a method for manufacturing the same, and a semiconductor structure, which are at least beneficial to reducing the overall horizontal area occupied by the staircase structure and improving the integration density of the conductive pillars in the staircase structure.

According to some embodiments of the present disclosure, in one aspect, the embodiments of the present disclosure provide a staircase structure. The staircase structure includes: a plurality of conductive layers spaced apart along a first direction, where each of the plurality of conductive layers includes at least two sub-conductive layers spaced apart along a second direction, and each of the plurality of conductive layers extends along a third direction, the first direction, the second direction, and the third direction intersecting with each other; and a plurality of step structures spaced apart along the second direction, a column of the sub-conductive layers spaced apart along the first direction being in contact connection with at least one of the plurality of step structures; where each of the plurality of step structures includes a plurality of conductive pillars electrically insulated from each other, each one of the plurality of conductive pillars is in contact connection with a corresponding one of the sub-conductive layers, and each conductive pillar in contact connection with a corresponding sub-conductive layer is electrically insulated from other sub-conductive layers; and in a column of the conductive layers spaced apart along the first direction, the conductive layers are in contact connection with the conductive pillars in a one-to-one manner.

In some embodiments, each of the plurality of conductive pillars includes a main body part and an epitaxial part; the main body part extends along the first direction, and the epitaxial part is located on a side wall, extending along the first direction, of a portion of the main body part; the epitaxial part is in contact connection with the corresponding sub-conductive layer, and the epitaxial part and the corresponding sub-conductive layer that are in contact connection are in a same layer; and a plurality of the main body parts in a same step structure are spaced apart along the third direction, and a plurality of the epitaxial parts in the same step structure are located in different layers, respectively.

In some embodiments, each conductive pillar further includes at least one extension part; the extension part is located on the side wall, extending along the first direction, of a portion of the main body part, and the at least one extension part and the epitaxial part that are in contact connection with a same conductive pillar are spaced apart along the first direction, the extension part and the sub-conductive layers being electrically insulated from each other.

In some embodiments, in the at least one extension part in contact connection with a same conductive pillar, each one of the at least one extension part and a corresponding one of the sub-conductive layers are at a same layer; or the at least one extension part in contact connection with the same conductive pillar is located on one side of the epitaxial part along the first direction.

In some embodiments, the second direction and the third direction jointly form a reference plane, and an orthographic projection area of the at least one of the extension part on the reference plane is smaller than an orthographic projection area of the epitaxial part on the reference plane.

In some embodiments, the main body part is provided with a first surface and a second surface opposite to each other in the first direction, and in the same step structure, along the third direction, distances between different epitaxial parts and the first surface in the first direction progressively increase or progressively decrease.

In some embodiments, a column of the sub-conductive layers spaced apart along the first direction is in contact connection with a corresponding one of the step structures, and two of the sub-conductive layers adjacent along the second direction serve as a first sub-conductive layer and a second sub-conductive layer, respectively; where a step structure in contact connection with the first sub-conductive layer is located on one side, distal to the second sub-conductive layer, of the first sub-conductive layer along the second direction, or the step structure in contact connection with the first sub-conductive layer is located between the first sub-conductive layer and the second sub-conductive layer; and a step structure in contact connection with the second sub-conductive layer is located on one side, distal to the first sub-conductive layer, of the second sub-conductive layer along the second direction, or the step structure in contact connection with the second sub-conductive layer is located between the second sub-conductive layer and the first sub-conductive layer.

In some embodiments, one column of the sub-conductive layers spaced apart along the first direction is in contact connection with two of the step structures, and the two step structures in contact connection with the same one column of the sub-conductive layers are located on two opposite sides of the column of the sub-conductive layers in the second direction, respectively.

In some embodiments, spacings between the plurality of conductive pillars and the plurality of conductive layers in each of the step structures are equal in the second direction.

According to some embodiments of the present disclosure, in another aspect, the embodiments of the present disclosure further provide a semiconductor structure. The semiconductor structure includes: the staircase structure according to any one of the above embodiments; and a plurality of signal transmission layers spaced apart along the first direction, the plurality of signal transmission layers being in contact with the conductive layers in a one-to-one manner, and the sub-conductive layers in a same conductive layer being all in contact with a same signal transmission layer, where each of the plurality of signal transmission layers includes a word line or a bit line.

According to some embodiments of the present disclosure, in yet another aspect, the embodiments of the present disclosure further provide a method for manufacturing a staircase structure. The methods includes: forming a plurality of conductive layers spaced apart along a first direction, where each of the plurality of conductive layers includes at least two sub-conductive layers spaced apart along a second direction, and each of the plurality of conductive layers extends along a third direction, the first direction, the second direction, and the third direction intersecting with each other; and forming a plurality of step structures spaced apart along the second direction, a column of the sub-conductive layers spaced apart along the first direction being in contact connection with at least one of the plurality of step structures; where each of the plurality of step structures includes a plurality of conductive pillars electrically insulated from each other, each one of the plurality of conductive pillars is in contact connection with a corresponding one of the sub-conductive layers, and each conductive pillar in contact connection with a corresponding sub-conductive layer is electrically insulated from other sub-conductive layers; and in a column of the conductive layers spaced apart along the first direction, the conductive layers are in contact connection with the conductive pillars in a one-to-one manner.

In some embodiments, steps of forming the conductive layer includes: forming a stack structure, where the stack structure includes first dielectric layers and second dielectric layers alternately stacked along the first direction; performing a first patterning process on the stack structure to form a trench penetrating through the stack structure; laterally etching the second dielectric layers exposed by the trench to form grooves between adjacent first dielectric layers, with each side of the trench in the second direction being in communication with one of the grooves; forming one of the sub-conductive layers in one of the grooves; and forming a third dielectric layer in the trench, where a plurality of the sub-conductive layers in contact connection with a same third dielectric layer form one of the conductive layers.

In some embodiments, steps of forming the step structures include: performing a second patterning process on the stack structure to form a plurality of through holes penetrating through the stack structure and spaced apart along the third direction, where the plurality of through holes spaced apart along the third direction constitute one through hole group, and the one column of the sub-conductive layers spaced apart along the first direction corresponds to at least one through hole group; forming a first sacrificial layer in the through holes, where in a plurality of the through holes corresponding to a same one column of the conductive layers spaced apart along the first direction, the first sacrificial layer located in the different through holes has different thicknesses in the first direction, and the first sacrificial layer with a smallest thickness is in contact connection with one layer of the first dielectric layers and one layer of the second dielectric layers; forming a fourth dielectric layer conformally covering remaining side walls of the through holes; removing the first sacrificial layer in contact connection with one layer of the second dielectric layers by using the fourth dielectric layer as a protective layer, where remaining through holes not filled by the first sacrificial layer serve as sub-through holes, so that each of the sub-through holes exposes one layer of the second dielectric layers; laterally etching the second dielectric layers exposed by the sub-through holes to form epitaxial grooves between adjacent first dielectric layers, where the epitaxial grooves expose the sub-conductive layers, and the epitaxial grooves are in communication with the sub-through holes; and removing a remaining first sacrificial layer, and forming the conductive pillars in the through holes and the epitaxial grooves, where a plurality of the conductive pillars formed in a same through hole group constitute one of the step structures.

In some embodiments, before forming the fourth dielectric layer and after forming the first sacrificial layer, the method further includes: laterally etching the second dielectric layers exposed by the through holes to form extension grooves between adjacent first dielectric layers, where the extension grooves expose remaining second dielectric layers, and the extension grooves are in communication with the through holes; the step of forming the fourth dielectric layer further includes: forming the fourth dielectric layer conformally covering surfaces of the extension grooves; and the step of forming the conductive pillars includes: forming the conductive pillars in the extension grooves.

In some embodiments, one layer of the first dielectric layers and one layer of the second dielectric layers adjacent to each other along the first direction constitute one sub-stack structure, and in the plurality of through holes corresponding to the same one column of the conductive layers spaced apart along the first direction, the number of sub-stack structures, which are in contact connection with the first sacrificial layer located in the different through holes, varies.

In some embodiments, in at least two through hole groups corresponding to one column of the conductive layers spaced apart along the first direction, any one of the at least two through hole groups is located on one of two opposite sides of the conductive layer in the second direction, or any one of the at least two through hole groups is located between adjacent sub-conductive layers.

In some embodiments, a material of the first dielectric layers is silicon oxide, and a material of the second dielectric layers is silicon nitride.

In some embodiments, a material of the first sacrificial layer is a spin-on dielectric layer.

The technical solutions according to the embodiments of the present disclosure at least have the following advantages.

A novel staircase structure is designed. The features of the steps are integrated onto the conductive pillars to form a novel step structure. In the novel step structure, the conductive pillars themselves are not only configured to conduct electricity to transmit electrical signals, but also configured to achieve electrical contact with conductive layers located at different layers. Compared with the current situation where a plurality of steps at different levels are separately designed, and conductive pillars in a one-to-one correspondence with the plurality of steps are separately designed, resulting in a relatively large overall horizontal area occupied by the steps and the conductive pillars, in an embodiment of the present disclosure, integrating the features of the steps onto the conductive pillars is beneficial to reducing the overall horizontal area occupied by the staircase structure while ensuring that the electrical signal on each conductive layer is led out through one conductive pillar. In other words, it is beneficial for improving the integration density of the conductive pillars in the staircase structure.

### BRIEF DESCRIPTION OF DRAWINGS

One or more embodiments are illustrated by figures in corresponding drawings, and the exemplary illustration is not to be construed as limiting the embodiments. Elements with the same reference numeral in the drawings represent similar elements. Unless otherwise specified, the figures in the drawings do not constitute limitations in terms of scale. For a clearer illustration of the technical solutions in the embodiments of the present disclosure or the conventional technology, the drawings required to be used in the embodiments are briefly described below. It is clear that the drawings in the description below are only some embodiments of the present disclosure, and for those of ordinary skill in the art, other drawings can be obtained based on these drawings without creative efforts.
FIG. 1 is a schematic top view of a staircase structure according to an embodiment of the present disclosure;
FIG. 2 is another schematic top view of a staircase structure according to an embodiment of the present disclosure;
FIG. 3 is a schematic cross-sectional diagram of the staircase structure shown in FIG. 1 or FIG. 2 along a first cross-sectional direction AA1;
FIG. 4 is a schematic cross-sectional diagram of the staircase structure shown in FIG. 1 or FIG. 2 along a second cross-sectional direction BB1;
FIG. 5 is a schematic diagram showing a partial three-dimensional structure of a conductive layer and a conductive pillar in the staircase structure shown in FIG. 1;
FIG. 6 is an orthographic projection view of the staircase structure shown in FIG. 1 on a plane of a film layer where one conductive layer of the staircase structure is located;
FIG. 7 is an orthographic projection view of the staircase structure shown in FIG. 1 on a plane of a film layer where another conductive layer of the staircase structure is located;
FIG. 8 is an orthographic projection view of the staircase structure shown in FIG. 1 on a plane of a film layer where yet another conductive layer of the staircase structure is located;
FIG. 9 is yet another schematic top view of a staircase structure according to an embodiment of the present disclosure;
FIG. 10 is a schematic cross-sectional diagram of the staircase structure shown in FIG. 9 along a first cross-sectional direction AA1;
FIG. 11 is a schematic cross-sectional diagram of the staircase structure shown in FIG. 9 along a second cross-sectional direction BB1;
FIG. 12 is a schematic top view of a semiconductor structure according to another embodiment of the present disclosure;
FIG. 13 is a schematic cross-sectional diagram of the semiconductor structure shown in FIG. 12 along a third cross-sectional direction CC1; and
FIGS. 14 to 26 are schematic cross-sectional diagrams corresponding to steps in a method for manufacturing a staircase structure according to yet another embodiment of the present disclosure.

### DESCRIPTION OF EMBODIMENTS

As is known from the background, the layout space occupied by a lead-out structure in a three-dimensional semiconductor device needs to be reduced.

It has been found through analysis that as the number of stacked layers of signal transmission layers, such as bit lines or word lines, in the three-dimensional semiconductor device increases, the number of required steps corresponding to each layer of the signal transmission layers also increases accordingly, and any two different steps need to be in different layers, resulting in an increase in the horizontal area occupied by the layout of all steps in the case of a relatively large number of steps. Moreover, conductive pillars need to be designed in a one-to-one correspondence with the steps. Since there is almost no gap in the horizontal direction between adjacent steps, but a gap is required between adjacent conductive pillars to avoid interference, the horizontal layout area of a single step should not be overly reduced to prevent the spacing between adjacent conductive pillars from being too close and causing interference. This results in a bottleneck in the reduction of layout space of the lead-out structure formed by a plurality of steps and a plurality of conductive pillars.

The embodiments of the present disclosure provide a staircase structure, a method for manufacturing the same, and a semiconductor structure. In the staircase structure, the features of the steps are integrated onto the conductive pillars to form a novel step structure. In the novel step structure, the conductive pillars themselves are not only configured to conduct electricity to transmit electrical signals, but also configured to achieve electrical contact with conductive layers located at different layers. Compared with the current situation where a plurality of steps at different levels are separately designed, and conductive pillars in a one-to-one correspondence with the plurality of steps are separately designed, resulting in a relatively large overall horizontal area occupied by the steps and the conductive pillars, in an embodiment of the present disclosure, integrating the features of the steps onto the conductive pillars is beneficial to reducing the overall horizontal area occupied by the staircase structure while ensuring that the electrical signal on each conductive layer is led out through one conductive pillar. In other words, it is beneficial for improving the integration density of the conductive pillars in the staircase structure.

The embodiments of the present disclosure will be described in detail below with reference to the drawings. However, those of ordinary skill in the art can understand that in the embodiments of the present disclosure, numerous technical details are set forth in order to enable readers to better understand the embodiments of the present disclosure. However, the technical solutions claimed by the embodiments of the present disclosure can also be implemented even without these technical details and the various changes and modifications based on the following embodiments.

An embodiment of the present disclosure provides a staircase structure. The staircase structure according to the embodiment of the present disclosure is described in detail below with reference to the drawings.

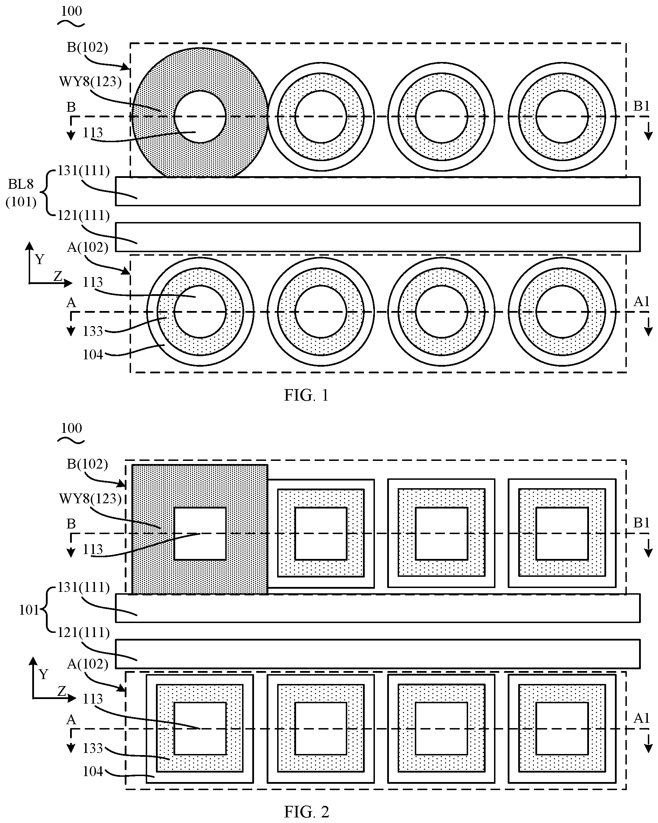

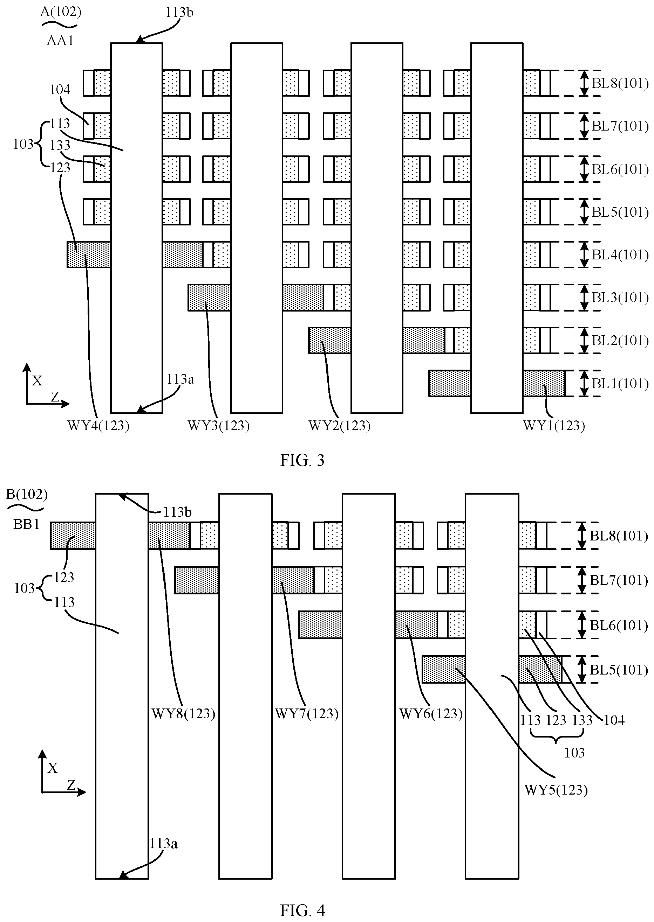

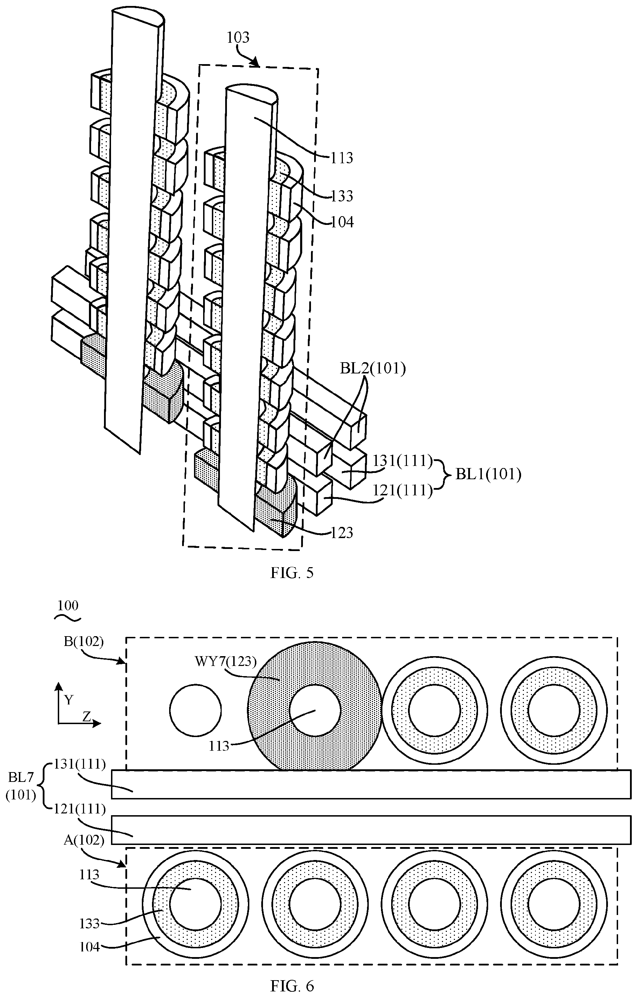

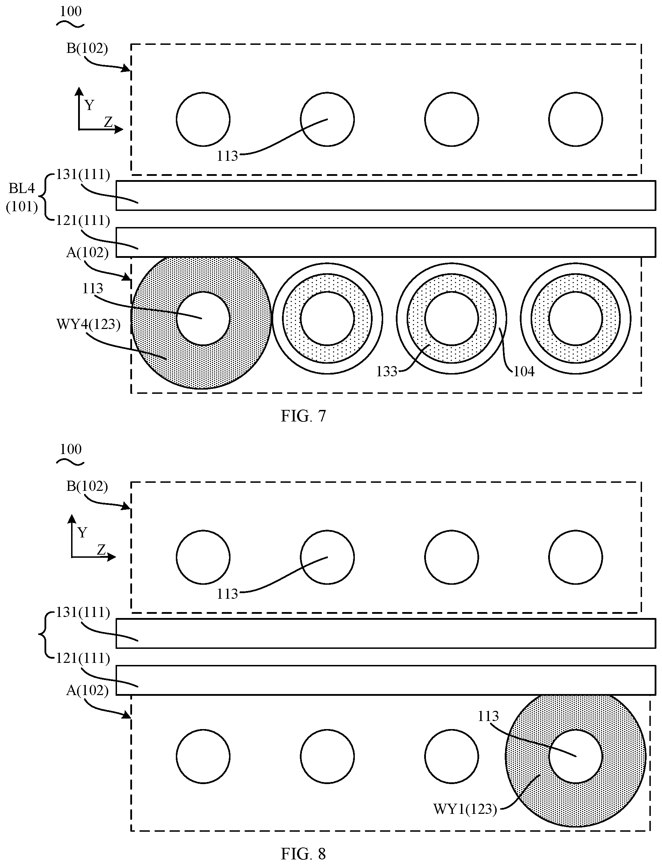

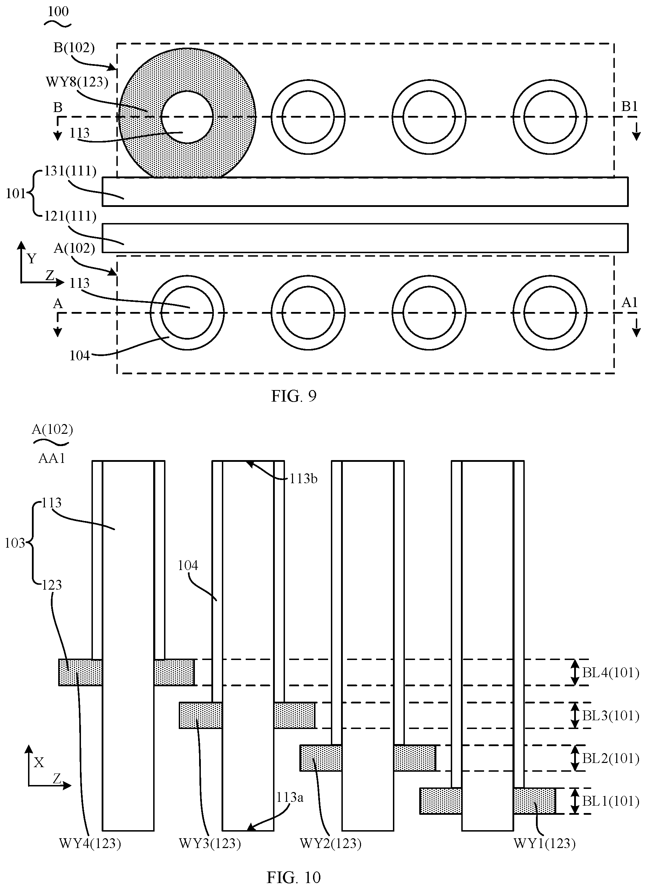

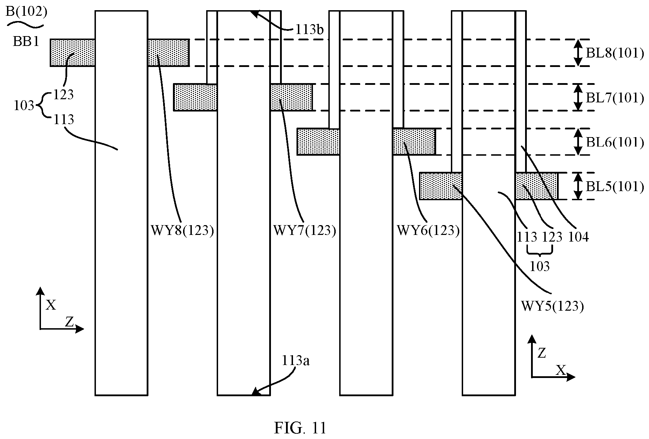

FIG. 1 is a schematic top view of a staircase structure according to an embodiment of the present disclosure; FIG. 2 is another schematic top view of a staircase structure according to an embodiment of the present disclosure; FIG. 3 is a schematic cross-sectional diagram of the staircase structure shown in FIG. 1 or FIG. 2 along a first cross-sectional direction AA1; FIG. 4 is a schematic cross-sectional diagram of the staircase structure shown in FIG. 1 or FIG. 2 along a second cross-sectional direction BB1; FIG. 5 is a schematic diagram showing a partial three-dimensional structure of a conductive layer and a conductive pillar in the staircase structure shown in FIG. 1; FIG. 6 is an orthographic projection view of the staircase structure shown in FIG. 1 on a plane of a film layer where one conductive layer of the staircase structure is located; FIG. 7 is an orthographic projection view of the staircase structure shown in FIG. 1 on a plane of a film layer where another conductive layer of the staircase structure is located; FIG. 8 is an orthographic projection view of the staircase structure shown in FIG. 1 on a plane of a film layer where yet another conductive layer of the staircase structure is located; FIG. 9 is yet another schematic top view of a staircase structure according to an embodiment of the present disclosure; FIG. 10 is a schematic cross-sectional diagram of the staircase structure shown in FIG. 9 along a first cross-sectional direction AA1; and FIG. 11 is a schematic cross-sectional diagram of the staircase structure shown in FIG. 9 along a second cross-sectional direction BB1.

It should be noted that, for convenience of description and clear illustration of the staircase structure, FIGS. 1 to 11 in an embodiment of the present disclosure are all schematic diagrams showing a partial structure of the staircase structure.

Referring to FIGS. 1, 2, or 9, the staircase structure 100 includes: a plurality of conductive layers 101 spaced apart along a first direction X, where each conductive layer 101 includes at least two sub-conductive layers 111 spaced apart along a second direction Y, and the conductive layer 101 extends along a third direction Z, the first direction X, the second direction Y, and the third direction Z intersecting with each other; and a plurality of step structures 102 spaced apart along the second direction Y, one column of sub-conductive layers 111 spaced apart along the first direction X being in contact connection with at least one step structure 102, where each step structure 102 includes a plurality of conductive pillars 103 electrically insulated from each other, one conductive pillar 103 is in contact connection with one sub-conductive layer 111, and the conductive pillar 103 in contact connection with the one sub-conductive layer 111 is electrically insulated from other sub-conductive layers 111; and in a column of conductive layers 101 spaced apart along the first direction X, the conductive layers 101 are in contact connection with the conductive pillars 103 in a one-to-one manner.

It should be noted that, firstly, in FIGS. 1, 2, or 9, the example shows that one conductive layer 101 includes two sub-conductive layers 111 spaced apart along the second direction Y. In practical applications, the number of sub-conductive layers 111, which are spaced apart along the second direction Y and included in one conductive layer 101, is not limited; for example, the number is 3, 4, or 5. It can be understood that, according to the number of conductive layers 101 spaced apart along the first direction X in practical applications, the number of sub-conductive layers 111, which are spaced apart along the second direction Y and included in one conductive layer 101, can be flexibly adjusted. For example, if the number of conductive layers 101 spaced apart along the first direction X is relatively large, the number of sub-conductive layers 111 spaced apart along the second direction Y and included in one conductive layer 101 can be increased.

Secondly, in FIGS. 1, 2, or 9, the example shows that one column of sub-conductive layers 111 spaced apart along the first direction X is in contact connection with one step structure 102. In practical applications, one column of sub-conductive layers 111 spaced apart along the first direction X may also be in contact connection with two step structures 102, which will be described in detail later.

Referring to FIGS. 1, 3, and 5, in the staircase structure 100, one conductive pillar 103 corresponds to only one conductive layer 101, and the conductive pillar 103 is only in contact connection with one sub-conductive layer 111 in the conductive layer 101 and is electrically insulated from other sub-conductive layers 111 in the conductive layer 101. In other words, there is spacing. In this way, the conductive layers 101 are in contact connection with the conductive pillars 103 in a one-to-one manner, so that the electrical signal on any conductive layer 101 can be transmitted outward through a corresponding conductive pillar 103.

It should be noted that one conductive layer 101 includes at least two sub-conductive layers 111, and among the at least two sub-conductive layers 111 belonging to the same conductive layer 101, only one sub-conductive layer 111 needs to be in contact connection with one conductive pillar 103, so that the conductive layer 101 can be in contact connection with the conductive pillar 103. In other words, each conductive pillar 103 is in contact connection with one sub-conductive layer 111, but not all sub-conductive layers 111 are each in contact connection with one conductive pillar 103; that is, among at least two sub-conductive layers 111 belonging to the same conductive layer 101, it suffices that one sub-conductive layer 111 is in contact connection with one conductive pillar 103, while other sub-conductive layers 111 belonging to the same conductive layer 101 are insulated from the conductive pillar 103.

It should be noted that the conductive layer 101 in the staircase structure 100 is subsequently in electrical contact with a signal transmission layer in the semiconductor structure, so as to lead out the electrical signal in the signal transmission layer through the conductive layer 101; that is, the staircase structure 100 may be regarded as a lead-out structure. In practical applications, the signal transmission layer in the semiconductor structure includes, but is not limited to, a bit line or a word line. Based on this, for the clarity of the subsequent description, eight conductive layers 101 spaced apart along the first direction X are respectively illustrated as BL1, BL2, BL3, BL4, BL5, BL6, BL7, and BL8 in FIGS. 3 and 4. It can be understood that the conductive layer 101 is not a bit line (not shown in the figure); rather, the conductive layer 101 is in electrical contact with the bit line to transmit the electrical signal to the bit line or transmit the electrical signal on the bit line to other electrical devices. In FIGS. 3 and 4, BL is used to schematically represent the conductive layer 101 for the purpose of illustrating the corresponding relationship between different conductive layers 101 and different bit lines. In practical applications, the conductive layer may also be in electrical contact with a word line to transmit the electrical signal to the word line or transmit the electrical signal on the word line to other electrical devices.

In addition, in FIGS. 3 and 4, the example shows that eight conductive layers 101 are spaced apart along the first direction X. In practical applications, the number of conductive layers 101 spaced apart along the first direction X is not limited, and may be determined based on the number of signal transmission layers that are in a one-to-one correspondence with the conductive layers and spaced apart along the first direction X.

As can be seen from the above description, according to an embodiment of the present disclosure, a novel staircase structure 100 is designed. The features of the steps are integrated onto the conductive pillars 103 to form a novel step structure 102. In the novel step structure 102, the conductive pillars 103 themselves are not only configured to conduct electricity to transmit electrical signals, but also configured to achieve electrical contact with conductive layers located at different layers. Compared with the current situation where a plurality of steps at different levels are separately designed, and conductive pillars in a one-to-one correspondence with the plurality of steps are separately designed, resulting in a relatively large overall horizontal area occupied by the steps and the conductive pillars, in an embodiment of the present disclosure, integrating the features of the steps onto the conductive pillars 103 is beneficial to reducing the overall horizontal area occupied by the staircase structure 100 while ensuring that the electrical signal on each conductive layer 101 is led out through one conductive pillar 103. In other words, it is beneficial for improving the integration density of the conductive pillars 103 in the staircase structure 100.

In some cases, the spacings between a plurality of conductive pillars 103 in one step structure 102 and the conductive layers 101 are equal in the second direction Y; that is, the plurality of conductive pillars 103 are arranged in a concentrated manner around the conductive layer 101, which helps ensure a short transmission path for the electrical signal between each conductive layer 101 and the conductive pillar 103 that is in contact connection with the conductive layer.

The staircase structure, according to an embodiment of the present disclosure, is described in detail below.

In some embodiments, referring to FIGS. 1 and 3 to 5 or FIGS. 2, 3, and 4, the conductive pillar 103 includes a main body part 113 and an epitaxial part 123; the main body part 113 extends along the first direction X, and the epitaxial part 123 is located on a side wall, extending along the first direction X, of a portion of the main body part 113; the epitaxial part 123 is in contact connection with the corresponding sub-conductive layer 111, and the epitaxial part 123 and the corresponding sub-conductive layer 111 that are in contact connection are in the same layer. Moreover, a plurality of main body parts 113 in the same step structure 102 are spaced apart along the third direction Z, and a plurality of epitaxial parts 123 in the same step structure 102 are located in different layers, respectively.

It should be noted that one main body part 113 is provided with only one epitaxial part 123 to ensure that one conductive pillar 103 is in contact connection with one sub-conductive layer 111 through only one epitaxial part 123. In FIG. 3, in order to distinguish different epitaxial parts 123 that are in contact connection with different sub-conductive layers 111, i.e., different conductive layers 101, the epitaxial part 123 in contact connection with the conductive layer BL1 is denoted as WY1, the epitaxial part 123 in contact connection with the conductive layer BL2 is denoted as WY2, the epitaxial part 123 in contact connection with the conductive layer BL3 is denoted as WY3, and the epitaxial part 123 in contact connection with the conductive layer BL4 is denoted as WY4. Similarly, in FIG. 4, in order to distinguish different epitaxial parts 123 that are in contact connection with different sub-conductive layers 111, i.e., different conductive layers 101, the epitaxial part 123 in contact connection with the conductive layer BL5 is denoted as WY5, the epitaxial part 123 in contact connection with the conductive layer BL6 is denoted as WY6, the epitaxial part 123 in contact connection with the conductive layer BL7 is denoted as WY7, and the epitaxial part 123 in contact connection with the conductive layer BL8 is denoted as WY8.

With continued reference to FIGS. 1 and 3 to 5 or FIGS. 2, 3, and 4, the conductive pillar 103 may further include at least one extension part 133. The extension part 133 is located on the side wall, extending along the first direction X, of a portion of the main body part 113, and the extension part 133 and the epitaxial part 123 that are in contact connection with the same conductive pillar 103 are spaced apart along the first direction X. The extension part 133 and the sub-conductive layer 111 are electrically insulated from each other.

It can be understood that, in one aspect, the length of the main body part 113 along the first direction X is relatively long, and the length penetrates through the plurality of conductive layers 101 spaced apart along the first direction X. As a result, the ratio of the length of the main body part 113 along the first direction X to the length of the main body part along the third direction Z is relatively large, such that the main body part 113 is prone to fracture in the middle due to its excessive length. Based on this, at least one extension part 133 is designed on the side wall of the main body part 113 extending along the first direction X, which is beneficial to reducing the probability of fracture in the middle of the main body part 113 by the support of the extension part 133 to the main body part 113, thereby helping to improve the structural stability of the main body part 113 itself and improve the structural stability of the conductive pillar 103.

In another aspect, at least one extension part 133 is designed on the side wall of the main body part 113 extending along the first direction X, which is beneficial to increasing the volume of the conductive pillar 103 and reducing the resistance of the conductive pillar 103 itself, thereby helping to improve the electrical performance of the conductive pillar 103.

It should be noted that, in order to clearly illustrate the three-dimensional structure of the conductive pillar 103, only two conductive pillars 103 and two conductive layers 101 in contact connection with the conductive pillars 103 are illustrated in FIG. 5. Moreover, in order to clearly illustrate the positional relationship among the main body part 113, the epitaxial part 123, and the extension part 133 in the conductive pillar 103, FIG. 5 only illustrates the three-dimensional structure of half of the conductive pillar 103.

It should be noted that, firstly, in some embodiments, referring to FIG. 4, the conductive pillar 103, which is in contact connection with the conductive layer 101 located on the topmost surface, i.e., BL8, is only provided with the epitaxial part 123 and not provided with the extension part 133. Secondly, in some embodiments, referring to FIGS. 3 to 5, among the at least one extension part 133 in contact connection with the same conductive pillar 103, one extension part 133 and one sub-conductive layer 111 are in the same layer. In other words, for the same conductive pillar 103, the epitaxial part 123 and the extension part 133, which are located on the side wall of the conductive pillar extending along the first direction X, are both in the same layer as one conductive layer 101. Thirdly, in some embodiments, referring to FIGS. 3 to 5, the at least one extension part 133 in contact connection with the same conductive pillar 103 is located on one side of the epitaxial part 123 along the first direction X. It should be noted that, along the first direction X, a base substrate (not shown in the figure) supporting the staircase structure may be further configured under the staircase structure 100, and the base substrate is located on one side, distal to the conductive layer BL2, of the conductive layer BL1. Based on this, that the at least one extension part 133 in contact connection with the same conductive pillar 103 is located on one side of the epitaxial part 123 along the first direction X means that the at least one extension part 133 in contact connection with the same conductive pillar 103 is located on one side, distal to the base substrate, of the epitaxial part 123.

It can be understood that the presence of the above various cases is related to the process flow of manufacturing the staircase structure 100, which will be described in detail later. In practical applications, by using some process methods to manufacture the staircase structure 100, the staircase structure 100 may exhibit the above various cases; by using some other process methods to manufacture the staircase structure 100, the staircase structure 100 may not exhibit the above various cases.

It should be noted that in the examples shown in FIGS. 1 to 5, in one aspect, there are eight conductive layers 101 spaced apart along the first direction X, and based on this, eight conductive pillars 103 are designed to be in contact connection with the conductive layers 101 in a one-to-one manner; in another aspect, one conductive layer 101 includes two sub-conductive layers 111 spaced apart along the second direction Y, and the one column of sub-conductive layers 111 spaced apart along the first direction X are in contact connection with one step structure 102. Based on this, two step structures 102 are designed, and the two step structures 102 are distinguished by A and B in FIGS. 1 to 4. In addition, one step structure 102 is designed to include four conductive pillars 103 arranged along the third direction Z. Under the above premise, seven conductive layers 101 are further spaced apart along the first direction X on one side, distal to the base substrate, of the epitaxial part WY1, and thus seven extension parts 133 are designed to be spaced apart along the first direction X on the side wall of the main body part 113 in contact connection with the epitaxial part WY1; six conductive layers 101 are further spaced apart along the first direction X on one side, distal to the base substrate, of the epitaxial part WY2, and thus six extension parts 133 are designed to be spaced apart along the first direction X on the side wall of the main body part 113 in contact connection with the epitaxial part WY2..., and so on; one conductive layer 101 is further spaced apart along the first direction X on one side, distal to the base substrate, of the epitaxial part WY7, and thus one extension part 133 is designed to be spaced apart along the first direction X on the side wall of the main body part 113 in contact connection with the epitaxial part WY7; zero conductive layer 101 is further spaced apart along the first direction X on one side, distal to the base substrate, of the extension part WY8, and thus zero extension part 133 is designed to be spaced apart along the first direction X on the side wall of the main body part 113 in contact connection with the epitaxial part WY8.

In some embodiments, referring to FIGS. 1 to 5, the step structure 102 may further include an insulating part 104, and the insulating part 104 surrounds the side wall of the extension part 133 that extends along the first direction X. It can be understood that the insulating part 104 is in a one-to-one correspondence with the extension part 133, which is beneficial to improving the structural stability of the conductive pillar 103 by means of the extension part 133 and improving the electrical performance of the conductive pillar 103, while avoiding, by means of the insulating part 104, the contact connection between the extension part 133 and the sub-conductive layer 111 located on the same layer as the extension part. As a result, the contact connection between one conductive pillar 103 and one sub-conductive layer 111 is achieved, and the conductive pillar 103 in contact connection with the sub-conductive layer 111 is electrically insulated from other sub-conductive layers 111. Moreover, it is beneficial that, by means of the insulating part 104, the contact connection between the epitaxial part 123 of one of the conductive pillars 103 and the extension part 133 of another, the conductive pillars being adjacent along the third direction Z, is avoided, so as to avoid the short circuit between adjacent conductive pillars 103 in the same step structure 102, thereby helping to improve the electrical performance of the staircase structure 100.

In some embodiments, referring to FIGS. 1 to 5, in the conductive pillars 103 adjacent to each other along the third direction Z, only the insulating part 104 is provided between the epitaxial part 123 and the extension part 133 in the same layer. In practical applications, in the conductive pillars 103 adjacent to each other along the third direction Z, not only the insulating part 104, but also other insulating dielectric layers may be provided between the epitaxial part 123 and the extension part 133 in the same layer.

In some embodiments, referring to FIGS. 1 to 5, a spacing may also be provided between the insulating part 104 and the sub-conductive layer 111, and other insulating dielectric layers may be provided in the spacing.

It should be noted that, in some examples, the plane formed by the second direction Y and the third direction Z is used as a projection plane. In FIGS. 1 and 5 to 8, the example shows that the orthographic projection shape of the main body part 113 is circular, and the orthographic projection shapes of the epitaxial part 123, the extension part 133, and the insulating part 104 are annular. In some other examples, referring to FIG. 2, the plane formed by the second direction Y and the third direction Z is used as a projection plane. In FIG. 2, the example shows that the orthographic projection shape of the main body part 113 is square, and the orthographic projection shapes of the epitaxial part 123, the extension part 133, and the insulating part 104 are square rings. Moreover, in the example shown in FIG. 2, the epitaxial part 123 is provided with four side walls extending along the first direction X, and one of the side walls is in contact connection with the sub-conductive layer 111, which helps ensure a relatively large contact area between the epitaxial part 123 and the sub-conductive layer 111, thereby ensuring a relatively large transmission efficiency for electrical signals between the conductive pillar 103 and the conductive layer 101. In practical applications, the orthographic projection shapes of the main body part, the epitaxial part, the extension part, and the insulating part may also be other shapes, and the orthographic projection shapes of the four parts are not limited in the embodiment of the present disclosure.

It should be noted that in the examples shown in FIGS. 1 and 6 to 8, the orthographic projection shape of the epitaxial part 123 on the plane formed by the second direction Y and the third direction Z is quasi-annular. Specifically, the orthographic projection shape of the portion of the epitaxial part 123 in contact connection with the sub-conductive layer 111 is a straight line rather than an arc, which is beneficial to increasing the contact area between the epitaxial part 123 and the sub-conductive layer 111, thereby improving the transmission efficiency for the electrical signals between the conductive pillar 103 and the conductive layer 101. In practical applications, the orthographic projection shape of the epitaxial part on the plane formed by the second direction and the third direction may also be a complete annular shape, in which case the epitaxial part is tangent to the sub-conductive layer.

In some embodiments, referring to FIG. 1, the radius of the insulating part 104 with an annular orthographic projection shape is less than or equal to the spacing in the second direction Y between the circle center of the main body part 113 and the sub-conductive layer 111 capable of transmitting electrical signals with the main body part, which helps ensure that there is a complete insulating part 104 between the extension part 133 and the sub-conductive layer 111 located on the same layer as the extension part, thereby avoiding the contact connection between the extension part 133 and the sub-conductive layer 111 located on the same layer as the extension part. It should be noted that in the example shown in FIG. 2, the spacing relationship among the insulating part 104, the main body part 113, and the sub-conductive layer 111 capable of transmitting electrical signals with the main body part is similar, which will not be described again here.

In some embodiments, referring to FIG. 1, on the plane formed by the second direction Y and the third direction Z, the maximum spacing between the circle center of the main body part 113 and the epitaxial part 123 is greater than or equal to the spacing between the circle center of the main body part 113 and the sub-conductive layer 111 capable of transmitting electrical signals with the main body part in the second direction Y, which helps ensure the contact connection between the epitaxial part 123 and the sub-conductive layer 111. It should be noted that in the example shown in FIG. 2, the spacing relationship among the main body part 113, the epitaxial part 123, and the sub-conductive layer 111 in contact connection with the epitaxial part is similar, which will not be described again here.

In some embodiments, referring to FIGS. 1 to 7, the second direction Y and the third direction Z jointly form a reference plane, and the orthographic projection area of the extension part 133 on the reference plane is smaller than the orthographic projection area of the epitaxial part 123 on the reference plane.

It should be noted that in all the examples shown in FIGS. 1 to 8, the conductive pillar 103 further includes the extension part 133 in addition to the main body part 113 and the epitaxial part 123. In some other embodiments, referring to FIGS. 9 to 11, the conductive pillar 103 only includes a main body part 113 and an epitaxial part 123; the main body part 113 extends along the first direction X, and the epitaxial part 123 is located on the side wall, extending along the first direction X, of a portion of the main body part 113; the epitaxial part 123 is in contact connection with the corresponding sub-conductive layer 111, and the epitaxial part 123 and the corresponding sub-conductive layer 111 that are in contact connection are in the same layer. Moreover, a plurality of main body parts 113 in the same step structure 102 are spaced apart along the third direction Z, and a plurality of epitaxial parts 123 in the same step structure 102 are located in different layers, respectively.

It should be noted that in the examples shown in FIGS. 9 to 11, the same or similar parts as those in the foregoing examples shown in FIGS. 1 to 8 will not be described again here.

It can be understood that any conductive pillar 103 includes only one main body part 113 extending along the first direction X and one epitaxial part 123 located on the side wall, extending along the first direction X, of a portion of the main body part 113. In this way, while ensuring that any conductive pillar 103 is in contact connection with the conductive layer 101 corresponding to the conductive pillar, it is beneficial to increasing the spacing in the second direction Y between the conductive layer 101 and other portions, apart from the epitaxial parts 123, of other conductive pillars 103 other than the conductive pillar 103, so as to ensure that the conductive layer 101 is in contact connection with the conductive pillar 103 in a one-to-one manner. In addition, it is beneficial to increasing the spacing in the third direction Z between most regions of adjacent conductive pillars 103, thereby helping to reduce the electrical interference between adjacent conductive pillars 103 along the third direction Z.

With continued reference to FIGS. 9 to 11, the step structure 102 may further include an insulating part 104, and the insulating part 104 surrounds the side wall of the main body part 113 that extends along the first direction X. It can be understood that the insulating part 104 is in a one-to-one correspondence with the main body part 113, which is beneficial to improving the insulation performance between the conductive layer 101 and the region of the main body part 113 other than the partial region surrounded by the epitaxial part 123.

In some embodiments, referring to FIGS. 9 to 11, the side wall of the main body part 113 that is not surrounded by the epitaxial part 123 is divided into an upper portion and a lower portion, and the insulating part 104 surrounds the side wall of the upper portion of the main body part 113 in the conductive pillar 103 corresponding to the insulating part. The side wall of the upper portion of the main body part 113 is the side wall of the main body part 113 located on one side, distal to the base substrate, of the epitaxial part 123.

In some embodiments, referring to FIGS. 9 to 11, a spacing may also be provided between the insulating part 104 and the sub-conductive layer 111, and other insulating dielectric layers may be provided in the spacing.

In the above embodiments, referring to FIGS. 3 and 4 or FIGS. 10 and 11, the main body part 113 is provided with a first surface 113a and a second surface 113b opposite to each other in the first direction X. In the same step structure 102, along the third direction Z, distances between different epitaxial parts 123 and the first surface 113a in the first direction X progressively increase or progressively decrease. In this way, it helps ensure that different epitaxial parts 123 are in contact connection with conductive layers 101 located on different layers, thereby helping to improve the arrangement regularity between different epitaxial parts 123 in the step structure 102.

It should be noted that distances between the epitaxial parts 123 and the first surface 113a in different step structures 102 in the first direction X are also different. In addition, the first surface 113a may be the bottom surface, proximal to the base substrate, of the conductive pillar 103.

In the various embodiments described above, based on the examples shown in FIGS. 1, 3, and 4, one column of sub-conductive layers 111 spaced apart along the first direction X are in contact connection with one step structure 102, and two sub-conductive layers 111 adjacent along the second direction Y serve as a first sub-conductive layer 121 and a second sub-conductive layer 131, respectively.

The positional relationship between the first sub-conductive layer 121 and the step structure 102 in contact connection with the first sub-conductive layer includes at least the following two types: In some cases, referring to FIG. 3, the step structure 102 in contact connection with the first sub-conductive layer 121 is located on one side, distal to the second sub-conductive layer 131, of the first sub-conductive layer 121 along the second direction Y; in some other cases, the step structure in contact connection with the first sub-conductive layer is located between the first sub-conductive layer and the second sub-conductive layer.

The positional relationship between the second sub-conductive layer 131 and the step structure 102 in contact connection with the second sub-conductive layer includes at least the following two types: In some cases, referring to FIG. 3, the step structure 102 in contact connection with the second sub-conductive layer 131 is located on one side, distal to the first sub-conductive layer 121, of the second sub-conductive layer 131 along the second direction Y; in some other cases, the step structure in contact connection with the second sub-conductive layer is located between the second sub-conductive layer and the first sub-conductive layer.

In this way, two columns of sub-conductive layers 111 adjacent to each other along the second direction Y serve as a group of sub-conductive layers. For the group of sub-conductive layers, the two step structures in contact connection with the group of sub-conductive layers include at least the following four layout types:

In some cases, referring to FIG. 3, the step structure 102 in contact connection with the first sub-conductive layer 121 is located on one side, distal to the second sub-conductive layer 131, of the first sub-conductive layer 121 along the second direction Y, and the step structure 102 in contact connection with the second sub-conductive layer 131 is located on one side, distal to the first sub-conductive layer 121, of the second sub-conductive layer 131 along the second direction Y. In this way, in the same conductive layer 101, the spacing between the first sub-conductive layer 121 and the second sub-conductive layer 131 in the second direction Y may be designed to be very small.

In some other cases, the step structure in contact connection with the first sub-conductive layer is located on one side, distal to the second sub-conductive layer, of the first sub-conductive layer along the second direction, and the step structure in contact connection with the second sub-conductive layer is located between the second sub-conductive layer and the first sub-conductive layer.

In yet other cases, the step structure in contact connection with the first sub-conductive layer is located between the first sub-conductive layer and the second sub-conductive layer, and the step structure in contact connection with the second sub-conductive layer is located on one side, distal to the first sub-conductive layer, of the second sub-conductive layer along the second direction.

In still other cases, the step structure in contact connection with the first sub-conductive layer is located between the first sub-conductive layer and the second sub-conductive layer, and the step structure in contact connection with the second sub-conductive layer is located between the second sub-conductive layer and the first sub-conductive layer.

In some embodiments, different from the case where "one column of sub-conductive layers 111 spaced apart along the first direction X are in contact connection with one step structure 102" in the above embodiment, one column of sub-conductive layers 111 spaced apart along the first direction X may be in contact connection with two step structures 102, and two step structures 102 in contact connection with the same one column of sub-conductive layers 111 are located on two opposite sides of the column of sub-conductive layers 111 in the second direction Y, respectively. In this way, the one column of sub-conductive layers 111 spaced apart along the first direction X is in contact connection with two step structures 102. For example, eight sub-conductive layers 111 are spaced apart along the first direction X, among which four sub-conductive layers 111 need to be in contact connection with two step structures 102, respectively. That is, one step structure 102 may be in contact connection with two of the four sub-conductive layers 111, and the other step structure 102 may be in contact connection with the remaining two of the four sub-conductive layers 111.

It can be understood that when the number of conductive layers 101 spaced apart along the first direction X is relatively large, for example, the number of conductive layers 101 spaced apart along the first direction X is M, and in order to ensure that each conductive layer 101 is provided with one step structure 102 in contact connection with the conductive layer, the layout space of the step structures 102 is reasonably planned, such that the length of the conductive layer 101 in the third direction Z matches the number of step structures 102 spaced apart along the third direction Z.

In one aspect, each conductive layer 101 may be divided into N sub-conductive layers 111 along the second direction, and in one column of sub-conductive layers 111 spaced apart along the first direction X, M/N sub-conductive layers 111 are designed to have a contact connection relationship with at least one step structure 102. As a result, each of the M conductive layers 101 can be in contact connection with M step structures 102. In another aspect, one column of sub-conductive layers 111 spaced apart along the first direction X may be in contact connection with one step structure 102 or two step structures 102. In the case of one step structure 102, the one step structure 102 is located on either of two opposite sides of the column of sub-conductive layers 111 in the second direction Y, so that the number of conductive pillars 103 arranged along the third direction Z in one step structure 102 can be reduced to M/N; in the case of two step structures 102, the two step structures 102 are respectively located on two opposite sides of the column of sub-conductive layers 111 in the second direction Y, so that the number of conductive pillars 103 arranged along the third direction Z in one step structure 102 can be reduced to M/2N.

It can be understood that if each conductive layer 101 is divided into N sub-conductive layers 111 along the second direction, and the one column of sub-conductive layers 111 spaced apart along the first direction X are in contact connection with one step structure 102, the one column of conductive layers 101 spaced apart along the first direction X are in contact connection with N step structures; if each conductive layer 101 is divided into N sub-conductive layers 111 along the second direction, and the one column of sub-conductive layers 111 spaced apart along the first direction X are in contact connection with two step structures 102, the one column of conductive layers 101 spaced apart along the first direction X is in contact connection with 2N step structures.

It should be noted that one column of conductive layers 101 spaced apart along the first direction X includes N columns of sub-conductive layers 111, M and N both being positive integers. If M/N is a non-integer, M/N is rounded; that is, the largest integer not exceeding the real number M/N is taken, and the largest integer is referred to as P. In one column of conductive layers 101, P sub-conductive layers 111 of one of two adjacent columns of sub-conductive layers 111 in the N columns of sub-conductive layers 111 have a contact connection relationship with at least one step structure 102, and (M-P) sub-conductive layers 111 of the other column of sub-conductive layers have a contact connection relationship with at least one step structure 102. Similarly, if M/2N is a non-integer, M/2N is rounded and the integer is referred to as Q, such that the number of conductive pillars 103 arranged along the third direction Z in one step structure 102 is reduced to Q, and the number of conductive pillars 103 arranged along the third direction Z in another step structure 102 is reduced to (M/2-Q). Similarly, the above similar rounding operation and subsequent design may also be performed on M/2. It can be understood that the above describes the main concept of dividing the conductive layer 101 into sub-conductive layers 111, as well as the main concept of the corresponding relationship between one column of sub-conductive layers 111 spaced apart along the first direction X and the step structure 102. In practical applications, the above various numbers may be adjusted based on actual situations.

In addition, that the length of the conductive layer 101 in the third direction Z matches the number of step structures 102 spaced apart along the third direction Z means that, in the case where the length of the conductive layer 101 in the third direction Z is limited, the number of conductive pillars 103 spaced apart along the third direction Z in the step structure 102 is also limited, and as a result, the number of conductive layers 101 spaced apart along the first direction X is greater than the number of conductive pillars 103 that can be spaced apart along the third direction Z. Therefore, additional layout space needs to be considered for the surplus conductive pillars 103. Based on this, the measures taken include: first, dividing each conductive layer 101 into N sub-conductive layers 111 along the second direction; second, ensuring that the number of step structures 102 in contact connection with one column of sub-conductive layers 111 spaced apart along the first direction X is one or two.

Moreover, in practical applications, the conductive layer 101 may not be divided along the second direction Y. Instead, only two step structures 102 in contact connection with one column of conductive layers 101 spaced apart along the first direction X are designed, and the two step structures 102 are respectively located on two opposite sides of the column of conductive layers 101 along the second direction Y.

The one-to-one contact connection between the conductive layer 101 and the conductive pillar 103 is described in detail below with reference to FIGS. 1 and 3 to 8. FIG. 1 may be regarded as an orthographic projection view of the staircase structure 100 on the plane of the film layer where the conductive layer BL8 is located; FIG. 6 may be regarded as an orthographic projection view of the staircase structure 100 on the plane of the film layer where the conductive layer BL7 is located; FIG. 7 may be regarded as an orthographic projection view of the staircase structure 100 on the plane of the film layer where the conductive layer BL4 thereof is located; and FIG. 8 may be regarded as an orthographic projection view of the staircase structure 100 on the plane of the film layer where the conductive layer BL1 thereof is located.

In the eight conductive pillars 103 of the two step structures 102, referring to FIGS. 1 and 3, on the plane of the film layer where the conductive layer BL8 is located, the conductive pillar 103 with only the epitaxial part WY8 is in contact connection with the conductive layer BL8, while the other conductive pillars 103 are each provided with the extension part 133 on the plane of the film layer where the conductive layer BL8 is located. Referring to FIGS. 6 and 3, on the plane of the film layer where the conductive layer BL7 is located, the conductive pillar 103 with only the epitaxial part WY7 is in contact connection with the conductive layer BL7, and the conductive pillar 103 in contact connection with the conductive layer BL8 is provided with only the main body part 113 on this plane, while the other conductive pillars 103 are each provided with the extension part 133 on this plane. Similarly, on the plane of the film layer where the conductive layer BL6 is located, the conductive pillar 103 with only the epitaxial part WY6 is in contact connection with the conductive layer BL6, and the conductive pillars 103 in contact connection with the conductive layers BL8 and BL7 are provided with only the main body part 113 on this plane, while the other conductive pillars 103 are each provided with the extension part 133 on this plane; on the plane of the film layer where the conductive layer BL5 is located, the conductive pillar 103 with only the epitaxial part WY5 is in contact connection with the conductive layer BL5, and the conductive pillars 103 in contact connection with the conductive layers BL8, BL7, and BL6 are provided with only the main body part 113 on this plane, while the other conductive pillars 103 are each provided with the extension part 133 on this plane. Moreover, four conductive pillars 103 in contact connection with the conductive layers BL8, BL7, BL6, and BL5 form a step structure B, and the conductive pillars in the step structure B are all in contact connection with the second sub-conductive layer 131.

Referring to FIGS. 7 and 4, on the plane of the film layer where the conductive layer BL4 is located, the conductive pillar 103 with only the epitaxial part WY4 is in contact connection with the conductive layer BL4, and the conductive pillars 103 in contact connection with the conductive layers BL8, BL7, BL6, and BL5 are provided with only the main body part 113 on this plane, while the other conductive pillars 103 are each provided with the extension part 133 on this plane. Similarly, on the plane of the film layer where the conductive layer BL3 is located, the conductive pillar 103 with only the epitaxial part WY3 is in contact connection with the conductive layer BL3, and the conductive pillar 103 in contact connection with the conductive layers BL8, BL7, BL6, BL5, and BL4 are provided with only the main body part 113 on this plane, while the other conductive pillars 103 are each provided with the extension part 133 on this plane. On the plane of the film layer where the conductive layer BL2 is located, the conductive pillar 103 with only the epitaxial part WY2 is in contact connection with the conductive layer BL2, and the conductive pillars 103 in contact connection with the conductive layers BL8, BL7, BL6, BL5, BL4, and BL3 are provided with only the main body part 113 on this plane, while the other conductive pillars 103 are each provided with the extension part 133 on this plane. Referring to FIGS. 8 and 3, on the plane of the film layer where the conductive layer BL1 is located, the conductive pillar 103 with only the epitaxial part WY1 is in contact connection with the conductive layer BL1, while the other conductive pillars 103 are each provided with only the main body part 113 on this plane. Moreover, four conductive pillars 103 in contact connection with the conductive layers BL4, BL3, BL2, and BL1 form a step structure A, and the conductive pillars in the step structure A are all in contact connection with the first sub-conductive layer 121.

In summary, the features of the steps are integrated onto the conductive pillars 103 to form a novel step structure 102. In the novel step structure 102, the conductive pillars 103 themselves are not only configured to conduct electricity to transmit electrical signals, but also configured to achieve electrical contact with conductive layers located at different layers. Compared with the current situation where a plurality of steps at different levels are separately designed, and conductive pillars in a one-to-one correspondence with the plurality of steps are separately designed, resulting in a relatively large overall horizontal area occupied by the steps and the conductive pillars, in an embodiment of the present disclosure, integrating the features of the steps onto the conductive pillars 103 is beneficial to reducing the overall horizontal area occupied by the step structure 102 while ensuring that the electrical signal on each conductive layer 101 is led out through one conductive pillar 103. In other words, it is beneficial for improving the integration density of the conductive pillars 103 in the step structure 102.

Another embodiment of the present disclosure further provides a semiconductor structure. The semiconductor structure includes the staircase structure according to an embodiment of the present disclosure. The semiconductor structure according to another embodiment of the present disclosure is described in detail below with reference to the drawings. It should be noted that the same or corresponding parts as those in the foregoing embodiments will not be described again here.

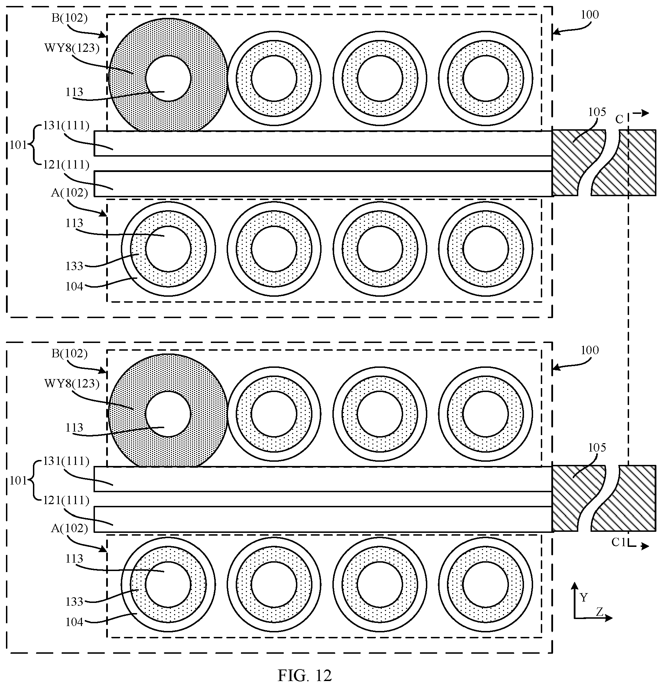

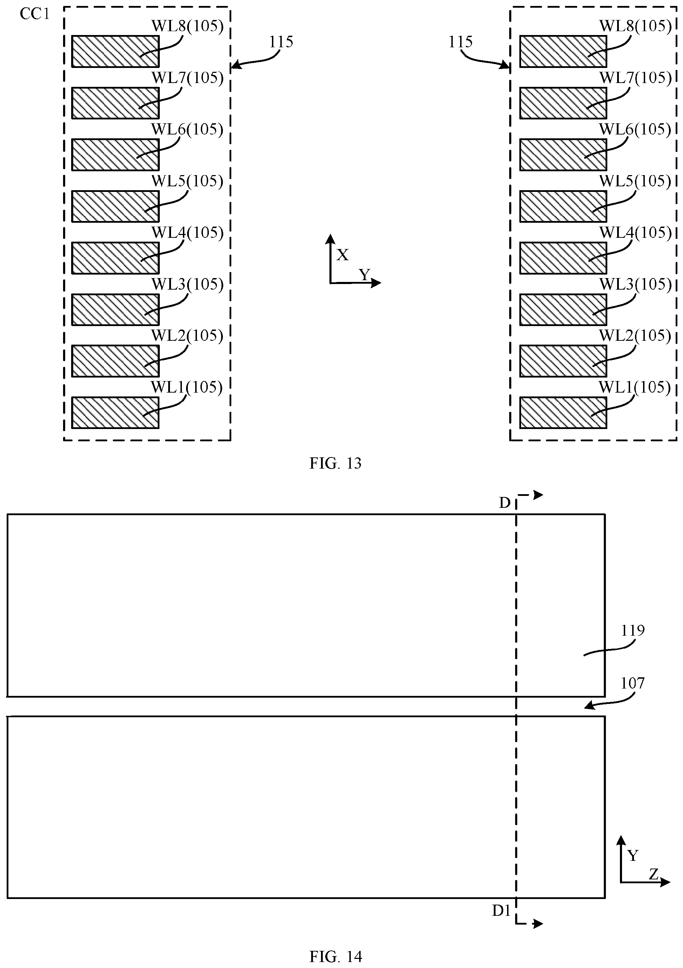

FIG. 12 is a schematic top view of a semiconductor structure according to another embodiment of the present disclosure; and FIG. 13 is a schematic cross-sectional diagram of the semiconductor structure shown in FIG. 12 along a third cross-sectional direction CC1. It should be noted that, for convenience of description and clear illustration of the semiconductor structure, FIGS. 12 and 13 in the embodiment are both schematic diagrams showing a partial structure of the semiconductor structure.

Referring to FIGS. 12 and 13, the semiconductor structure includes: the staircase structure 100 according to an embodiment of the present disclosure; and a plurality of signal transmission layers 105 spaced apart along a first direction X. The signal transmission layers 105 are in contact connection with the conductive layers 101 in a one-to-one manner, and the sub-conductive layers 111 in the same conductive layer 101 are all in contact connection with the same signal transmission layer 105. The signal transmission layer 105 includes a word line or a bit line.

It should be noted that in FIG. 12, the staircase structure 100 and the step structure 102 in the staircase structure 100 are illustrated by using dashed boxes in different forms. In addition, the signal transmission layer 105 shown in FIG. 12 is drawn in a simple manner. In practical applications, the extension length of the signal transmission layer 105 in the third direction Z is very long. For example, the extension length of the signal transmission layer 105 in the third direction Z is greater than the extension length of the conductive layer 101 in the third direction Z.

In some embodiments, the semiconductor structure may further include a transistor structure (not shown in the figure). If the signal transmission layer 105 is a bit line, the signal transmission layer 105 is in contact connection with a source or a drain in the transistor structure; if the signal transmission layer 105 is a word line, the signal transmission layer 105 surrounds a channel region in the transistor structure.

In some embodiments, with continued reference to FIGS. 12 and 13, the plurality of signal transmission layers spaced apart along the first direction X are one signal transmission group 115; a plurality of signal transmission groups 115 are spaced apart along the second direction Y, and one signal transmission group 115 corresponds to one staircase structure 100. In this way, electrical signals at all signal transmission layers 105 in one signal transmission group 115 may be respectively led out through a plurality of conductive pillars 103 in one staircase structure 100.

Yet another embodiment of the present disclosure further provides a method for manufacturing a staircase structure. The method is used to form the staircase structure according to an embodiment of the present disclosure. The method for manufacturing a staircase structure according to yet another embodiment of the present disclosure is described in detail below with reference to the drawings. FIGS. 14 to 26 are schematic cross-sectional diagrams corresponding to steps in a method for manufacturing a staircase structure according to yet another embodiment of the present disclosure. It should be noted that, for convenience of description and clear illustration of the steps in the method for manufacturing a staircase structure, FIGS. 14 to 26 in the embodiment are all schematic diagrams showing a partial structure of the staircase structure. The same or corresponding parts as those in the foregoing embodiments will not be described again here.

It should be noted that yet another embodiment of the present disclosure takes the formation of the staircase structure 102 as shown in FIGS. 1, 3, and 4 as an example, to provide a detailed description of the method for manufacturing a staircase structure according to yet another embodiment of the present disclosure.

Referring to FIGS. 1, 3, 4, and 14 to 26, the method for manufacturing a staircase structure includes: forming a plurality of conductive layers 101 spaced apart along a first direction X, where each conductive layer 101 includes at least two sub-conductive layers 111 spaced apart along a second direction Y, and the conductive layer 101 extends along a third direction Z, the first direction X, the second direction Y, and the third direction Z intersecting with each other; and forming a plurality of step structures 102 spaced apart along the second direction Y, one column of sub-conductive layers 111 spaced apart along the first direction X being in contact connection with at least one step structure 102. Each step structure 102 includes a plurality of conductive pillars 103 electrically insulated from each other, one conductive pillar 103 is in contact connection with one sub-conductive layer 111, and the conductive pillar 103 in contact connection with the one sub-conductive layer 111 is electrically insulated from other sub-conductive layers 111; and in a column of conductive layers 101 spaced apart along the first direction X, the conductive layers 101 are in contact connection with the conductive pillars 103 in a one-to-one manner.

Each step in the manufacturing method is described in detail below with reference to the drawings.

In some embodiments, referring to FIGS. 14 to 17, forming the conductive layer 101 may include the following steps.

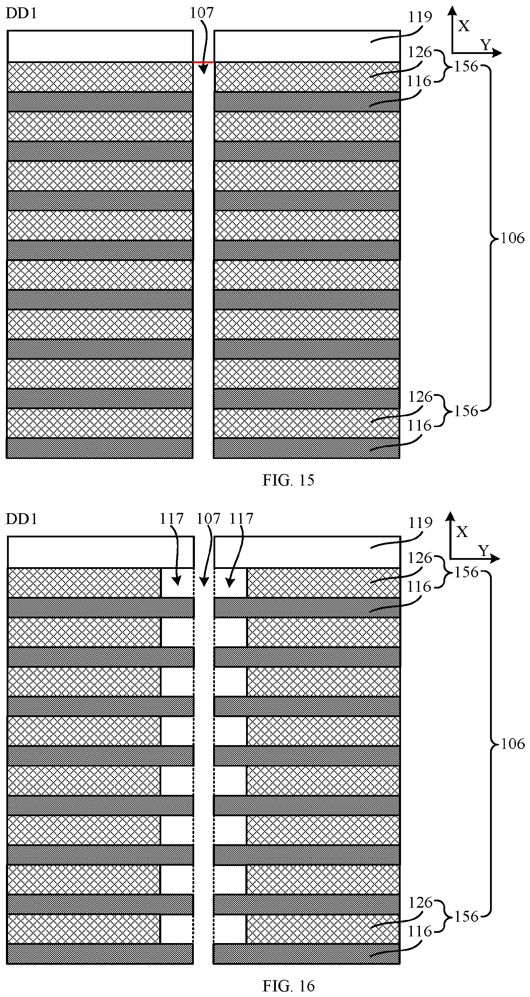

Referring to FIGS. 14 and 15, a stack structure 106 is formed, the stack structure 106 including first dielectric layers 116 and second dielectric layers 126 alternately stacked along the first direction X.

In some embodiments, a material of the first dielectric layer 116 is different from a material of the second dielectric layer 126. For example, the material of the first dielectric layer 116 is silicon oxide, and the material of the second dielectric layer 126 is silicon nitride.

FIG. 15 is a schematic cross-sectional diagram of the structure shown in FIG. 14 along a fourth cross-sectional direction DD1. It should be noted that the schematic cross-sectional diagram along the fourth cross-sectional direction DD1 will be provided as needed in subsequent descriptions. In addition, FIGS. 14 and 15 illustrate the stack structure 106 after a first patterning process.

With continued reference to FIGS. 14 and 15, the first patterning process is performed on the stack structure 106 to form a trench 107 penetrating through the stack structure 106.

In some embodiments, before the first patterning process is performed on the stack structure 106, a first mask layer 119 provided with an opening is further formed on a top surface of the stack structure 106, and subsequently, the first patterning process is performed on the stack structure 106 based on the first mask layer 119. It can be understood that the first dielectric layer 116 and the second dielectric layer 126 are etched without distinction during the first patterning process.

Referring to FIGS. 15 and 16, the second dielectric layers 126 exposed by the trench 107 are laterally etched to form grooves 117 between adjacent first dielectric layers 116, with each side of the trench 107 in the second direction Y being in communication with one groove 117. It can be understood that two adjacent grooves 117 along the second direction Y are subsequently used to form two sub-conductive layers 111, respectively, in the same conductive layer 101 shown in FIG. 1.

It should be noted that the material of the first dielectric layer 116 is different from the material of the second dielectric layer 126. In the step of laterally etching the second dielectric layers 126 exposed by the trench 107, the etching process has a relatively high etching rate only for the second dielectric layer 126, and hardly etches the first dielectric layer 116.

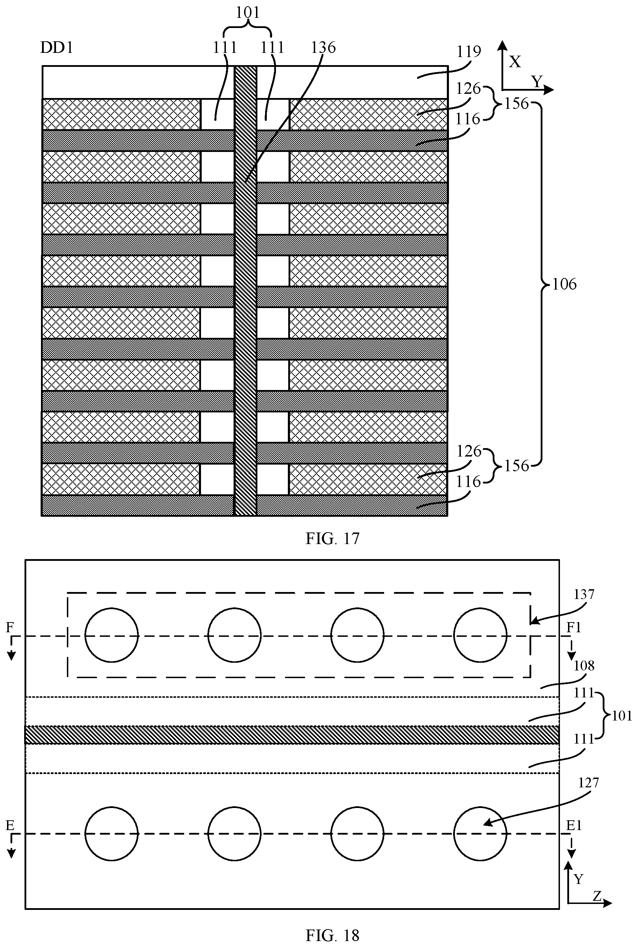

Referring to FIGS. 16 and 17, one sub-conductive layer 111 is formed in one groove 117, and a third dielectric layer 136 is formed in the trench 107. A plurality of sub-conductive layers 111 in contact connection with the same third dielectric layer 136 form one conductive layer 101.

It should be noted that in the examples shown in FIGS. 16 and 17, that the plurality of sub-conductive layers 111 in contact connection with the same third dielectric layer 136 form one conductive layer 101 means that two sub-conductive layers 111, which are in contact connection with the same third dielectric layer 136 and located on the same layer, form one conductive layer 101. In practical applications, a plurality of trenches spaced apart may be formed along the second direction, and one groove is formed on each of two sides of any trench in the second direction and is in communication with the trench, so as to form a conductive layer including a plurality of sub-conductive layers spaced apart along the second direction.

In some embodiments, a material of the third dielectric layer 136 may be the same as the material of the first dielectric layer 116, such as silicon oxide. In some other embodiments, the material of the third dielectric layer 136 may be different from the material of the first dielectric layer 116.

In some embodiments, referring to FIGS. 18 to 26, forming the step structure 102 may include the following steps.

Referring to FIG. 18, a second patterning process is performed on the stack structure 106 (referring to FIG. 17) to form a plurality of through holes 127 penetrating through the stack structure 106 and spaced apart along the third direction Z, where the plurality of through holes 127 spaced apart along the third direction Z constitute one through hole group 137, and one column of sub-conductive layers 111 spaced apart along the first direction X corresponds to at least one through hole group 137.

It should be noted that in order to illustrate the positional relationship between the through hole 127 and the conductive layer 101, relatively dense dashed lines are used in FIG. 18 to illustrate the approximate layout space occupied by the two sub-conductive layers 111 in the conductive layer 101. In addition, a relatively thick dashed box is used in FIG. 18 to illustrate one through hole group 137.

In addition, the conductive layer 101 includes at least two sub-conductive layers 111 spaced apart along the second direction Y. Based on this, one column of sub-conductive layers 111 spaced apart along the first direction X corresponds to at least one through hole group 137, and one column of conductive layers 101 spaced apart along the first direction X corresponds to at least two through hole groups 137.

In some embodiments, referring to FIG. 18, the top surface of the stack structure 106 (referring to FIG. 17) is further provided with a first mask layer 119. In the step of performing the second patterning process on the stack structure 106, the second patterning process is also performed on the first mask layer 119. It can be understood that the first dielectric layer 116, the second dielectric layer 126, and the first mask layer 119 are etched without distinction during the second patterning process.

In some embodiments, referring to FIG. 18, in the at least two through hole groups 137 corresponding to the one column of conductive layers 101 spaced apart along the first direction X, any one of the through hole groups 137 is located on one of two opposite sides of the conductive layer 101 in the second direction Y.

It can be understood that in FIG. 18, one of the two through hole groups 137 corresponding to the one column of conductive layers 101 spaced apart along the first direction X is located on one side of the two opposite sides of the conductive layer 101 in the second direction Y, and the other of the two through hole groups is located on the other side of the two opposite sides of the conductive layer 101 in the second direction Y. In practical applications, one of the two through hole groups corresponding to the one column of conductive layers spaced apart along the first direction is located on one side of the two opposite sides of the conductive layer in the second direction Y, and the other of the two through hole groups may be located between adjacent sub-conductive layers; or, the two through hole groups corresponding to the one column of conductive layers spaced apart along the first direction are both located between adjacent sub-conductive layers.

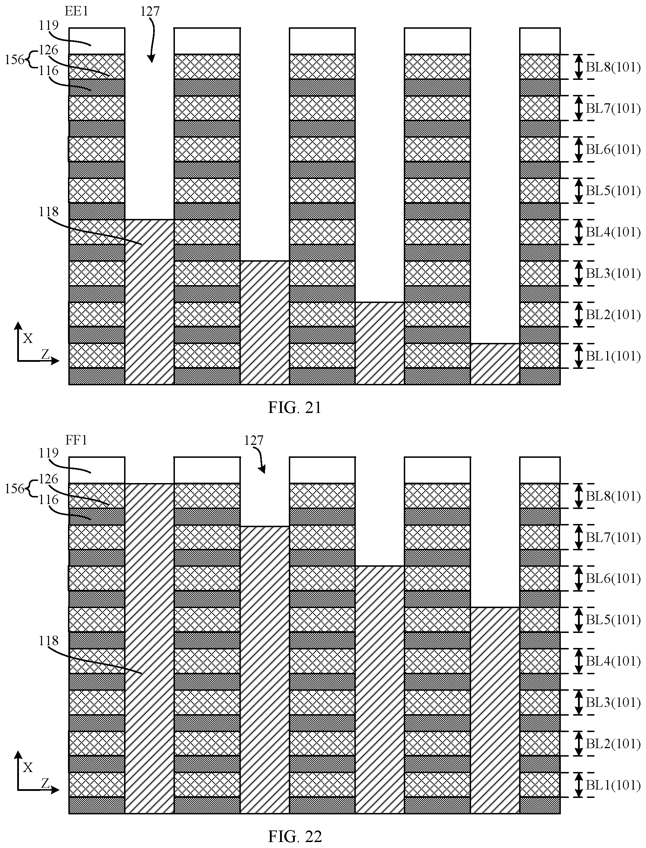

Referring to FIGS. 21 and 22, a first sacrificial layer 118 is formed in the through holes 127. In the plurality of through holes 127 corresponding to the same one column of conductive layers 101 spaced apart along the first direction X, the first sacrificial layer 118 located in different through holes 127 has different thicknesses in the first direction X, and the first sacrificial layer 118 with the smallest thickness is in contact connection with one layer of the first dielectric layers 116 and one layer of the second dielectric layers 126.

It should be noted that FIG. 21 is a schematic cross-sectional diagram of a structure along a fifth cross-sectional direction EE1 after the first sacrificial layer 118 is formed in the through hole 127 shown in FIG. 18, and FIG. 22 is a schematic cross-sectional diagram of a structure along a sixth cross-sectional direction FF1 after the first sacrificial layer 118 is formed in the through hole 127 shown in FIG. 18. In addition, the schematic cross-sectional diagram along at least one of the fifth cross-sectional direction EE1 and the sixth cross-sectional direction FF1 will be provided as needed in subsequent descriptions.

Referring to FIGS. 18 to 22, the step of forming the first sacrificial layer 118 may include the following steps.

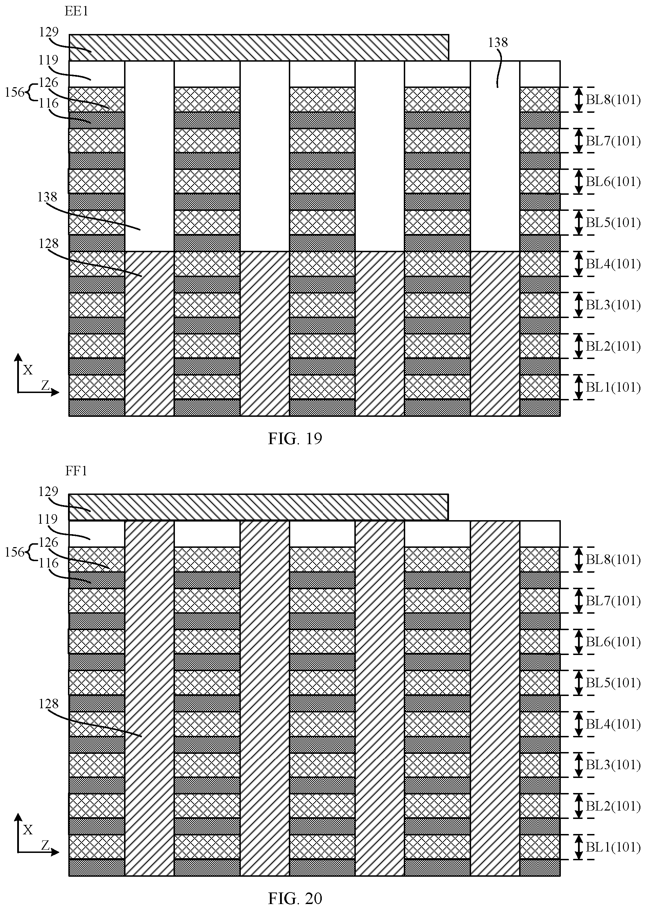

Referring to FIG. 18, an initial first sacrificial layer (not shown in the figure) is formed in the through hole 127 penetrating through the stack structure 106, with the initial first sacrificial layer filling the through hole 127. Referring to FIGS. 19 and 20, the initial first sacrificial layer located in one of the two through hole groups 137 (referring to FIG. 18) is etched to remove nearly half of the initial first sacrificial layer. Referring to FIG. 19, a partial region of the through hole 127 (referring to FIG. 18) above the remaining initial first sacrificial layer 128 in one of the two through hole groups 137 is exposed again, and the exposed partial region of the through hole 127 is filled with a second sacrificial layer 138. Referring to FIG. 20, the initial first sacrificial layer 128 located in the other of the two through hole groups 137 is not etched.

It should be noted that one layer of the first dielectric layers 116 and one layer of the second dielectric layers 126 adjacent to each other along the first direction X constitute one sub-stack structure 156, and the number of sub-stack structures 156 in the stack structure 106 is determined based on the number of conductive layers 101 in one column of conductive layers 101 spaced apart along the first direction X. Referring to FIG. 19, the number of sub-stack structures 156 in the stack structure 106 is eight, and removing nearly half of the initial first sacrificial layer refers to removing the initial first sacrificial layer corresponding to the upper four sub-stack structures 156. In practical applications, the number of sub-stack structures 156 in the stack structure 106 is M, M being a positive integer. If M is an even number, the initial first sacrificial layer corresponding to the upper M/2 sub-stack structures 156 is removed; if M is an odd number, the initial first sacrificial layer corresponding to the upper (M-1)/2 sub-stack structures 156 is removed.

It should be noted that a material of the initial first sacrificial layer 128 is different from a material of the second sacrificial layer 138. For example, the material of the initial first sacrificial layer 128 is a spin-on dielectric layer, and the spin-on dielectric layer is different from both the material of the first dielectric layer 116 and the material of the second dielectric layer 126. The material of the second sacrificial layer 138 is aluminum oxide, and aluminum oxide is also different from both the material of the first dielectric layer 116 and the material of the second dielectric layer 126.

With continued reference to FIGS. 19 and 20, a second mask layer 129 is formed on a top surface of the first mask layer 119, and the second mask layer 129 exposes two adjacent through holes 127 (referring to FIG. 18) along the second direction Y. One of the two adjacent through holes 127 along the second direction Y is provided with the second sacrificial layer 138 shown in FIG. 19, and the other of the two adjacent through holes is provided with the initial first sacrificial layer 128 shown in FIG. 20. Referring to FIGS. 19 and 21, as well as FIGS. 20 and 22, the second sacrificial layer 138 exposed by the second mask layer 129 is first removed, and then the initial first sacrificial layer 128 in two adjacent through holes 127 along the second direction Y is etched simultaneously to form the first sacrificial layer 118 that is flush with top surfaces of the conductive layers BL1 and BL5, as shown in FIGS. 21 and 22. In one example, the initial first sacrificial layer 128 in two adjacent through holes 127 along the second direction Y is etched simultaneously, and the portions of the initial first sacrificial layer 128 in contact connection with three sub-stack structures 156 are removed from the two through holes 127, respectively.

It can be understood that, similarly, the second mask layer 129 is removed, and a third mask layer (not shown in the figure) is formed on the top surface of the first mask layer 119. The third mask layer exposes another two adjacent through holes 127 (referring to FIG. 18) along the second direction Y, for example, exposing the third through hole 127 counted from left to right along the third direction Z in each through hole group 137 in FIG. 18. Referring to FIGS. 19 and 21, as well as FIGS. 20 and 22, the second sacrificial layer 138 exposed by the third mask layer is removed first, and then the initial first sacrificial layer 128 in the two adjacent through holes 127 along the second direction Y exposed by the third mask layer is etched simultaneously, to form the first sacrificial layer 118 that is flush with the top surfaces of the conductive layers BL2 and BL6, as shown in FIGS. 21 and 22. In one example, the initial first sacrificial layer 128 in two adjacent through holes 127 along the second direction Y exposed by the third mask layer is etched simultaneously, and the portions of the initial first sacrificial layer 128 in contact connection with two sub-stack structures 156 are removed from the two through holes 127, respectively.

The third mask layer is removed, and a fourth mask layer (not shown in the figure) is formed on the top surface of the first mask layer 119. The fourth mask layer exposes another two adjacent through holes 127 (referring to FIG. 18) along the second direction Y, for example, exposing the second through hole 127 counted from left to right along the third direction Z in each through hole group 137 in FIG. 18. Referring to FIGS. 19 and 21, as well as FIGS. 20 and 22, the second sacrificial layer 138 exposed by the fourth mask layer is removed first, and then the initial first sacrificial layer 128 in the two adjacent through holes 127 along the second direction Y exposed by the fourth mask layer is etched simultaneously, to form the first sacrificial layer 118 that is flush with the top surfaces of the conductive layers BL3 and BL7, as shown in FIGS. 21 and 22. In one example, the initial first sacrificial layer 128 in two adjacent through holes 127 along the second direction Y exposed by the fourth mask layer is etched simultaneously, and the portions of the initial first sacrificial layer 128 in contact connection with one sub-stack structure 156 are removed from the two through holes 127, respectively.

In addition, the fourth mask layer is removed, and a fifth mask layer (not shown in the figure) is formed on the top surface of the first mask layer 119. The fifth mask layer exposes another two adjacent through holes 127 (referring to FIG. 18) along the second direction Y, for example, exposing the first through hole 127 counted from left to right along the third direction Z in each through hole group 137 in FIG. 18. Referring to FIGS. 19 and 21, as well as FIGS. 20 and 22, the second sacrificial layer 138 exposed by the fifth mask layer is removed first, and then the initial first sacrificial layer 128 in contact connection with the first mask layer 119 is removed, to form the first sacrificial layer 118 that is flush with the top surfaces of the conductive layers BL4 and BL8, as shown in FIGS. 21 and 22.

In some embodiments, referring to FIGS. 21 and 22, one layer of the first dielectric layers 116 and one layer of the second dielectric layers 126 adjacent to each other along the first direction X constitute one sub-stack structure 156. In the plurality of through holes 127 corresponding to the same one column of conductive layers 101 spaced apart along the first direction X, the number of sub-stack structures 156 in contact connection with the first sacrificial layer 118 located in different through holes 127 varies. In this way, it is beneficial for the subsequent formation of conductive pillars in contact connection with conductive layers at different layers.

In some embodiments, referring to FIGS. 21 and 22, in the same through hole group 137 (referring to FIG. 18) along the third direction Z, the number of sub-stack structures 156 in contact connection with the first sacrificial layer 118 in different through holes 127 progressively increases or progressively decreases.

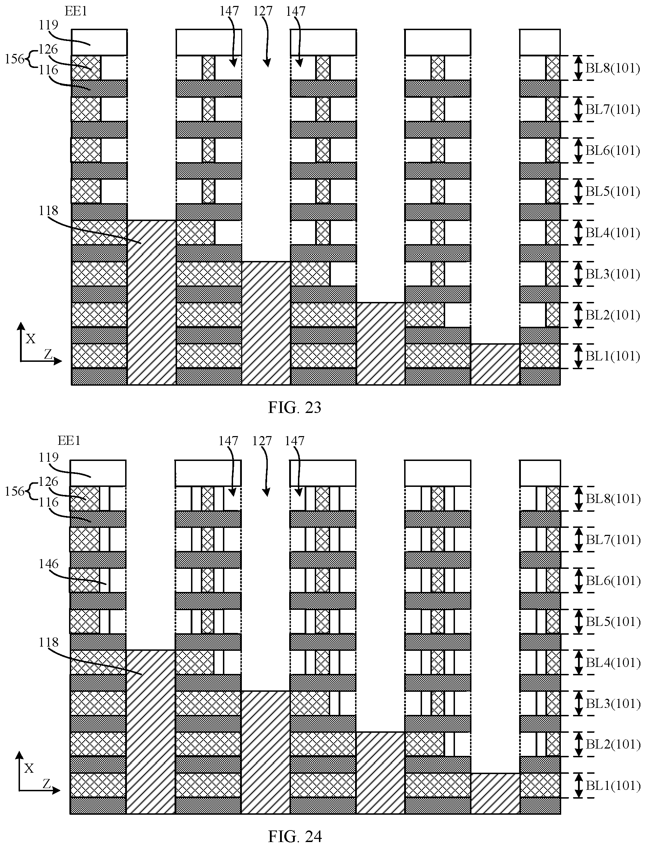

Referring to FIG. 24, a fourth dielectric layer 146 is formed. In some embodiments, to form the staircase structure 100 shown in FIG. 1, before the fourth dielectric layer 146 is formed and after the first sacrificial layer 118 is formed, the manufacturing method may further include: referring to FIGS. 21 and 23, laterally etching the second dielectric layer 126 exposed by the through hole 127 to form an extension groove 147 between adjacent first dielectric layers 116, where the extension groove 147 exposes the remaining second dielectric layer 126, and the extension groove 147 is in communication with the through hole 127. It can be understood that the extension groove 147 is used for the subsequent formation of the insulating part and the extension part.

It should be noted that the materials of the first dielectric layer 116, the second dielectric layer 126, and the first sacrificial layer 118 are different. In the step of laterally etching the second dielectric layer 126 exposed by the through hole 127, the etching process has a relatively high etching rate only for the second dielectric layer 126, and hardly etches the first dielectric layer 116 and the first sacrificial layer 118.

It should be noted that similar steps for transitioning the structure shown in FIG. 21 to the structure shown in FIG. 23 are also performed for the four through holes 127 in the structure shown in FIG. 22, which will not be further illustrated or described again here. Subsequent process steps performed for the structure shown in FIG. 23 are also performed for the structure shown in FIG. 22. Subsequent steps will be described in detail with the schematic cross-sectional diagram shown in FIG. 23.

In some embodiments, referring to FIGS. 23 and 24, on the basis of forming the extension groove 147 between adjacent first dielectric layers 116, the step of forming the fourth dielectric layer 146 may further include: forming the fourth dielectric layer 146 conformally covering the surface of the extension groove 147.

It should be noted that FIG. 24 only illustrates the fourth dielectric layer 146 located on a side wall, extending along the first direction X, of the extension groove 147. It can be understood that in practical applications, the fourth dielectric layer 146 may be formed only on the side wall, extending along the first direction X, of the extension groove 147, that is, on the side wall of the second dielectric layer 126 exposed by the extension groove 147, so as to prevent the subsequent etching process from etching this portion of the second dielectric layer 126. It can be understood that the fourth dielectric layer 146 shown in FIG. 24 is the insulating part 104 shown in FIG. 1.

In some cases, the step of forming the fourth dielectric layer 146 may include: forming an initial fourth dielectric layer conformally covering the surfaces of the through hole 127 and the extension groove 147, and etching the initial fourth dielectric layer. In the etching step, at least the portion of the initial fourth dielectric layer located on the top surface of the first sacrificial layer 118 is removed. Due to differences in etching processes, at least a portion of the initial fourth dielectric layer located on the side walls of the first mask layer 119 and the first dielectric layer 116 may also be etched, so that the remaining initial fourth dielectric layer is located on the surface of the extension groove 147.

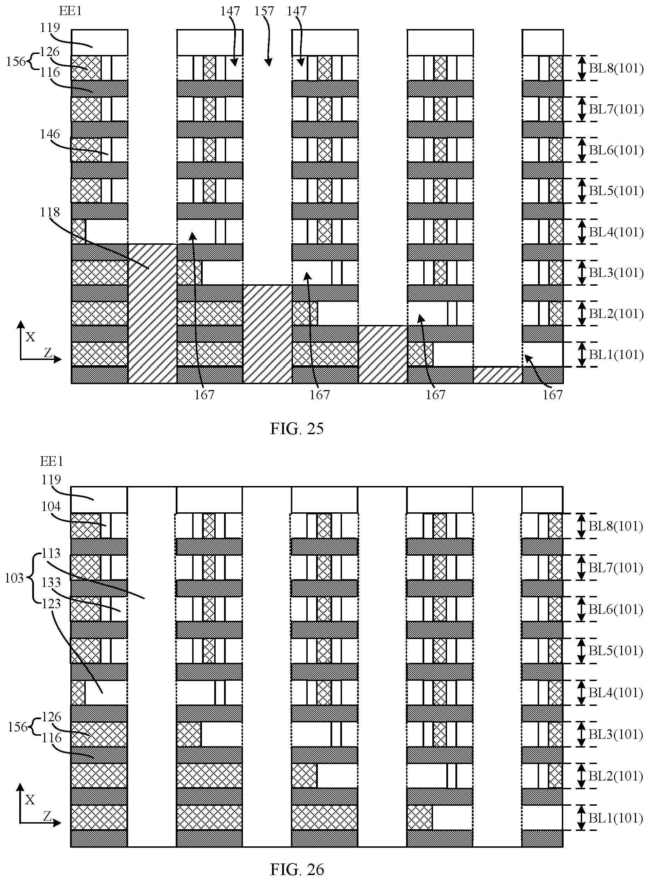

Referring to FIGS. 24 and 25, the first sacrificial layer 118 in contact connection with one layer of the second dielectric layers 126 is removed by using the fourth dielectric layer 146 as a protective layer, and the remaining through holes 127 not filled by the first sacrificial layer 118 serve as sub-through holes 157, so that each sub-through hole 157 exposes one layer of the second dielectric layers 126. With further reference to FIGS. 24 and 25, the second dielectric layer 126 exposed by the sub-through hole 157 is laterally etched to form an epitaxial groove 167 between adjacent first dielectric layers 116; the epitaxial groove 167 exposes the sub-conductive layer 111 (referring to FIG. 18), and the epitaxial groove 167 is in communication with the sub-through hole 157.

It should be noted that in the step of laterally etching the second dielectric layer 126 exposed by the sub-through hole 157, the etching process also has a relatively high etching rate only for the second dielectric layer 126, and hardly etches the first dielectric layer 116 and the first sacrificial layer 118.

Referring to FIGS. 25 and 26, the remaining first sacrificial layer 118 is removed, and a conductive pillar 103 is formed in the through hole 127 and the epitaxial groove 167. A plurality of conductive pillars 103 formed in the same through hole group 137 form one step structure 102. In some embodiments, on the basis that the extension groove 147 is formed between adjacent first dielectric layers 116, the step of forming the conductive pillar 103 includes: forming the conductive pillar 103 in the extension groove 147.

It can be understood that the conductive pillar 103 located in the through hole 127 (referring to FIG. 18) is the main body part 113 shown in FIG. 3, the conductive pillar 103 located in the epitaxial groove 167 (referring to FIG. 25) is the epitaxial part 123 shown in FIG. 3, and the conductive pillar 103 located in the extension groove 147 (referring to FIG. 25) is the extension part 133 shown in FIG. 3. Referring to FIG. 26, the main body part 113, the epitaxial part 123, and the extension part 133 in the conductive pillar 103 may be an integrally formed structure.

It should be noted that in the above embodiments, the method for manufacturing a staircase structure is described in detail by taking the formation of the conductive pillar 103 with the extension part 133 as an example. In practical applications, as shown in FIGS. 9 to 11, the conductive pillar 103 in the step structure 102 may include only the main body part 113 and the epitaxial part 123.

The formation of the step structure 102 shown in FIGS. 9 to 11 is briefly described below, and the same or similar parts as those in the method for manufacturing a step structure 102 shown in FIG. 1 will not be described again here.

In some other embodiments, referring to FIGS. 21 and 10, as well as FIGS. 22 and 11, the fourth dielectric layer conformally covering the remaining side wall of the through hole 127 (referring to FIG. 18) is directly formed without further forming the extension groove. It can be understood that the fourth dielectric layer conformally covering the remaining side wall of the through hole 127 (referring to FIG. 18) is the insulating part 104 shown in FIGS. 10 and 11.

The first sacrificial layer 118 in contact connection with one layer of the second dielectric layers 126 (referring to FIG. 21) is removed by using the fourth dielectric layer as the protective layer, and the remaining through holes 127 not filled by the first sacrificial layer 118 serve as sub-through holes 157 (referring to FIG. 25), so that each sub-through hole 157 exposes one layer of the second dielectric layers 126. It should be noted that in the example shown in FIG. 25, in which the staircase structure shown in FIG. 9 is formed, the extension groove may not be formed.

The second dielectric layer 126 exposed by the sub-through hole is laterally etched to form an epitaxial groove 167 (referring to FIG. 25) between adjacent first dielectric layers 116; the epitaxial groove 167 exposes the sub-conductive layer 111 (referring to FIG. 18), and the epitaxial groove 167 is in communication with the sub-through hole 157.

The remaining first sacrificial layer 118 is removed, and a conductive pillar 103 is formed in the through hole 127 and the epitaxial groove 167. A plurality of conductive pillars 103 formed in the same through hole group 137 form one step structure 102.

In summary, the manufacturing method according to yet another embodiment of the present disclosure is beneficial to forming a novel staircase structure 100, and the features of the steps are integrated onto the conductive pillars 103 to form a novel step structure 102. In the novel step structure 102, the conductive pillars 103 themselves are not only configured to conduct electricity to transmit electrical signals, but also configured to achieve electrical contact with conductive layers located at different layers. Compared with the current situation where a plurality of steps at different levels are separately designed, and conductive pillars in a one-to-one correspondence with the plurality of steps are separately designed, resulting in a relatively large overall horizontal area occupied by the steps and the conductive pillars, in an embodiment of the present disclosure, integrating the features of the steps onto the conductive pillars 103 is beneficial to reducing the overall horizontal area occupied by the staircase structure 102 while ensuring that the electrical signal on each conductive layer 101 is led out through one conductive pillar 103. In other words, it is beneficial for improving the integration density of the conductive pillars 103 in the staircase structure 102.

Those of ordinary skill in the art can understand that the foregoing implementations are specific embodiments of the present disclosure, and in practical applications, various changes may be made in form and detail without departing from the spirit and scope of the embodiments of the present disclosure. Any person skilled in the art can make various changes and modifications without departing from the spirit and scope of the embodiments of the present disclosure, and the protection scope of the embodiments of the present disclosure is defined by the appended claims.

## Claims

1. A staircase structure, comprising:
a plurality of conductive layers (101) spaced apart along a first direction (X), wherein each of the plurality of conductive layers (101) comprises at least two sub-conductive layers (111) spaced apart along a second direction (Y), and each of the plurality of conductive layers (101) extends along a third direction (Z), the first direction (X), the second direction (Y), and the third direction (Z) intersecting with each other;
a plurality of step structures (102) spaced apart along the second direction (Y), a column of the sub-conductive layers (111) spaced apart along the first direction (X) being in contact connection with at least one of the plurality of step structures (102);
wherein each of the plurality of step structures (102) comprises a plurality of conductive pillars (103) electrically insulated from each other, each one of the plurality of conductive pillars (103) is in contact connection with a corresponding one of the sub-conductive layers (111), and each conductive pillar (103) in contact connection with a corresponding sub-conductive layer (111) is electrically insulated from other sub-conductive layers (111); and in a column of the conductive layers (101) spaced apart along the first direction (X), the conductive layers (101) are in contact connection with the conductive pillars (103) in a one-to-one manner.

2. The staircase structure according to claim 1, wherein each of the plurality of conductive pillars (103) comprises a main body part (113) and an epitaxial part (123); the main body part (113) extends along the first direction (X), and the epitaxial part (123) is located on a side wall, extending along the first direction (X), of a portion of the main body part; the epitaxial part (123) is in contact connection with the corresponding sub-conductive layer (111), and the epitaxial part (123) and the corresponding sub-conductive layer (111) that are in contact connection are in a same layer; and
a plurality of the main body parts (113) in a same step structure (102) are spaced apart along the third direction (Z), and a plurality of the epitaxial parts (123) in the same step structure (102) are located in different layers, respectively.

3. The staircase structure according to claim 2, wherein each conductive pillar (103) further comprises at least one extension part (133); the extension part (133) is located on the side wall, extending along the first direction (X), of a portion of the main body part, and the at least one extension part (133) and the epitaxial part (123) that are in contact connection with a same conductive pillar (103) are spaced apart along the first direction (X), the extension part (133) and the sub-conductive layers (111) being electrically insulated from each other.

4. The staircase structure according to claim 3, wherein in the at least one extension part (133) in contact connection with a same conductive pillar (103), each one of the at least one extension part (133) and a corresponding one of the sub-conductive layers (111) are at a same layer; or the at least one extension part (133) in contact connection with the same conductive pillar (103) is located on one side of the epitaxial part (123) along the first direction (X).

5. The staircase structure according to claim 3, wherein the second direction (Y) and the third direction (Z) jointly form a reference plane, and an orthographic projection area of the at least one of the extension part (133) on the reference plane is smaller than an orthographic projection area of the epitaxial part (123) on the reference plane.

6. The staircase structure according to claim 2, wherein the main body part (113) is provided with a first surface and a second surface opposite to each other in the first direction (X), and in the same step structure (102), along the third direction (Z), distances between different epitaxial parts (123) and the first surface in the first direction (X) progressively increase or progressively decrease.

7. The staircase structure according to any one of claims 1 to 6, wherein a column of the sub-conductive layers (111) spaced apart along the first direction (X) is in contact connection with a corresponding one of the step structures (102), and two of the sub-conductive layers (111) adjacent along the second direction (Y) serve as a first sub-conductive layer (121) and a second sub-conductive layer (131), respectively;
wherein a step structure (A/102) in contact connection with the first sub-conductive layer (121) is located on one side, distal to the second sub-conductive layer (131), of the first sub-conductive layer (121) along the second direction (Y), or the step structure (A/102) in contact connection with the first sub-conductive layer (121) is located between the first sub-conductive layer (121) and the second sub-conductive layer (131); and
a step structure (B/102) in contact connection with the second sub-conductive layer (131) is located on one side, distal to the first sub-conductive layer (121), of the second sub-conductive layer (131) along the second direction (Y), or the step structure (B/102) in contact connection with the second sub-conductive layer (131) is located between the second sub-conductive layer (131) and the first sub-conductive layer (121).

8. The staircase structure according to any one of claims 1 to 6, wherein one column of the sub-conductive layers (111) spaced apart along the first direction (X) is in contact connection with two of the step structures (102), and the two step structures (102) in contact connection with the same one column of the sub-conductive layers (111) are located on two opposite sides of the column of the sub-conductive layers (111) in the second direction (Y), respectively.

9. The staircase structure according to any one of claims 1 to 6, wherein spacings between the plurality of conductive pillars (103) and the plurality of conductive layers (101) in each of the step structures (102) are equal in the second direction (Y).

10. A semiconductor structure, comprising:
the staircase structure according to any one of claims 1 to 9; and
a plurality of signal transmission layers (105) spaced apart along the first direction (X), the plurality of signal transmission layers (105) being in contact connection with the conductive layers (101) in a one-to-one manner, and the sub-conductive layers (111) in a same conductive layer (101) being all in contact connection with a same signal transmission layer (105);
wherein each of the plurality of signal transmission layers (105) comprises a word line or a bit line.

11. A method for manufacturing a staircase structure, comprising:
forming a plurality of conductive layers (101) spaced apart along a first direction (X), wherein each of the plurality of conductive layers (101) comprises at least two sub-conductive layers (111) spaced apart along a second direction (Y), and each of the plurality of conductive layers (101) extends along a third direction (Z), the first direction (X), the second direction (Y), and the third direction (Z) intersecting with each other; and
forming a plurality of step structures (102) spaced apart along the second direction (Y), a column of the sub-conductive layers (111) spaced apart along the first direction (X) being in contact connection with at least one of the plurality of step structures (102);
wherein each of the plurality of step structures (102) comprises a plurality of conductive pillars (103) electrically insulated from each other, each one of the plurality of conductive pillars (103) is in contact connection with a corresponding one of the sub-conductive layers (111), and each conductive pillar (103) in contact connection with a corresponding sub-conductive layer (111) is electrically insulated from other sub-conductive layers (111); and in a column of the conductive layers (101) spaced apart along the first direction (X), the conductive layers (101) are in contact connection with the conductive pillars (103) in a one-to-one manner.

12. The method according to claim 11, wherein steps of forming the conductive layers (101) comprise:
forming a stack structure (106), wherein the stack structure (106) comprises first dielectric layers (116) and second dielectric layers (126) alternately stacked along the first direction (X);
performing a first patterning process on the stack structure (106) to form a trench (107) penetrating through the stack structure (106);
laterally etching the second dielectric layers (126) exposed by the trench (107) to form grooves (117) between adjacent first dielectric layers (116), with each side of the trench (107) in the second direction (Y) being in communication with one of the grooves (117);
forming one of the sub-conductive layers (111) in one of the grooves (117); and
forming a third dielectric layer (136) in the trench (107), wherein a plurality of the sub-conductive layers (111) in contact connection with a same third dielectric layer (136) form one of the conductive layers (101).

13. The method according to claim 12, wherein steps of forming the step structures (102) comprise:
performing a second patterning process on the stack structure (106) to form a plurality of through holes (127) penetrating through the stack structure (106) and spaced apart along the third direction (Z), wherein the plurality of through holes (127) spaced apart along the third direction (Z) constitute one through hole group (137), and a column of the sub-conductive layers (111) spaced apart along the first direction (X) corresponds to at least one through hole group (137);
forming a first sacrificial layer (118) in the through holes (127), wherein in a plurality of the through holes (127) corresponding to a same one column of the conductive layers (101) spaced apart along the first direction (X), the first sacrificial layer (118) located in the different through holes (127) has different thicknesses in the first direction (X), and the first sacrificial layer (118) with a smallest thickness is in contact connection with one layer of the first dielectric layers (116) and one layer of the second dielectric layers (126);
forming a fourth dielectric layer (146) conformally covering remaining side walls of the through holes (127);
removing the first sacrificial layer (118) in contact connection with one layer of the second dielectric layers (126) by using the fourth dielectric layer (146) as a protective layer, wherein remaining through holes (127) not filled by the first sacrificial layer (118) serve as sub-through holes (157), so that each of the sub-through holes (157) exposes one layer of the second dielectric layers (126);
laterally etching the second dielectric layers (126) exposed by the sub-through holes (157) to form epitaxial grooves (167) between adjacent first dielectric layers (116), wherein the epitaxial grooves (167) expose the sub-conductive layers (111), and the epitaxial grooves (167) are in communication with the sub-through holes (157); and
removing a remaining first sacrificial layer (118), and forming the conductive pillars (103) in the through holes (127) and the epitaxial grooves (167), wherein a plurality of the conductive pillars (103) formed in a same through hole group (137) constitute one of the step structures (102).

14. The method according to claim 13, wherein before forming the fourth dielectric layer (146) and after forming the first sacrificial layer (118), the method further comprises:
laterally etching the second dielectric layers (126) exposed by the through holes (127) to form extension grooves (147) between adjacent first dielectric layers (116), wherein the extension grooves (147) expose remaining second dielectric layers (126), and the extension grooves (147) are in communication with the through holes (127);
a step of forming the fourth dielectric layer (146) further comprises: forming the fourth dielectric layer (146) conformally covering surfaces of the extension grooves (147); and
a step of forming the conductive pillars (103) comprises: forming the conductive pillars (103) in the extension grooves (147).

15. The method according to claim 13 or 14, wherein one layer of the first dielectric layers (116) and one layer of the second dielectric layers (126) adjacent to each other along the first direction (X) constitute one sub-stack structure (156), and in the plurality of through holes (127) corresponding to the same one column of the conductive layers (101) spaced apart along the first direction (X), a number of sub-stack structures (156), which are in contact connection with the first sacrificial layer (118) located in the different through holes (127), varies.

16. The method according to claim 13 or 14, wherein in at least two through hole groups (137) corresponding to one column of the conductive layers (101) spaced apart along the first direction (X), any one of the at least two through hole groups (137) is located on one of two opposite sides of the conductive layer (101) in the second direction (Y), or any one of the at least two through hole groups (137) is located between adjacent sub-conductive layers (111).

17. The method according to any one of claims 12 to 15, wherein a material of the first dielectric layers (116) is silicon oxide, and a material of the second dielectric layers (126) is silicon nitride.

18. The method according to claim 13, wherein a material of the first sacrificial layer (118) is a spin-on dielectric layer.
